# EUROPEAN PATENT APPLICATION

(11) **EP 4 692 945 A1**
(43) Date of publication of application: **11.02.2026**
(21) Application number: 24780874.4
(22) Date of filing: 29.03.2024
(51) Int. Cl.: G03F 7/11, G03F 7/26

(54) **COMPOSITION FOR FORMING RESIST UNDERLAYER FILM**

(30) Priority: 30.03.2023 JP 2023055954
(71) Applicant: Nissan Chemical Corporation, Tokyo 103-6119 (JP)
(72) Inventor: SHIMIZU Shou, Toyama-shi, Toyama 939-2792 (JP); KATO Yuki, Toyama-shi, Toyama 939-2792 (JP); IGATA Kosuke, Toyama-shi, Toyama 939-2792 (JP)
(74) Representative: Hoffmann Eitle
(86) International application number: PCT/JP2024/013227
(87) International publication number: WO 2024/204780

(57) **Abstract**

A resist underlayer film-forming composition, containing: a compound (A) including a side chain or a terminal having a chain α,β-unsaturated carbonyl group; and a solvent (B).

## Description

### Technical Field

The present invention relates to a resist underlayer film-forming composition, a resist underlayer film, a laminate, a method for producing a semiconductor element, and a pattern forming method.

### Background Art

Conventionally, microfabrication by lithography using a resist composition has been performed in the production of a semiconductor device. The microfabrication is a processing method of forming microrelief corresponding to a photoresist pattern on a substrate surface by forming a thin film of a photoresist composition on a semiconductor substrate such as a silicon wafer, irradiating the thin film with an active ray such as an ultraviolet ray through a mask pattern on which a device pattern is drawn, developing the thin film, and etching the substrate using the obtained photoresist pattern as a protective film. In recent years, semiconductor devices have become more highly integrated, and also as the active ray to be used, in addition to an i-line (wavelength: 365 nm), a KrF excimer laser (wavelength: 248 nm), and an ArF excimer laser (wavelength: 193 nm) that have been conventionally used, practical application of EUV light (wavelength: 13.5 nm) or an electron beam (EB) has been studied for the most advanced microfabrication. Along with this, poor resist pattern formation due to an influence of a semiconductor substrate or the like becomes a major problem. Therefore, in order to solve this problem, a method of providing a resist underlayer film between a resist and a semiconductor substrate has been widely studied.

As a resist underlayer film-forming composition, a resist underlayer film-forming composition containing a reaction product of a compound (A) represented by formula (1) (in formula (1), A represents an organic group containing an aliphatic ring, an aromatic ring or a heterocycle) dissolved in a solvent, a compound (B) having two functional groups reactive with an epoxy group, and a compound (C) having one functional group reactive with an epoxy group has been proposed (see Patent Literature 1).

### Citation List

### Patent Literature

Patent Literature 1: WO 2022/075339 A

### Summary of Invention

### Technical Problem

Examples of the characteristics required for a resist underlayer film include that no intermixing with a resist film formed on an upper layer occurs (the resist film is insoluble in a resist solvent), and a resist pattern with small roughness can be formed.

The present invention has been made in view of the above circumstances, and an object of the present invention is to provide a resist underlayer film-forming composition capable of forming a resist pattern with small roughness, and a resist underlayer film, a laminate, a method for producing a semiconductor element, and a pattern forming method using the resist underlayer film-forming composition.

### Solution to Problem

As a result of intensive studies to solve the above problem, the present inventors have found that the above problem can be solved, and have completed the present invention having the following gist.

That is, the present invention includes the following aspects.
[1] A resist underlayer film-forming composition, containing: a compound (A) including a side chain or a terminal having a chain α,β-unsaturated carbonyl group; and a solvent (B).
[2] The resist underlayer film-forming composition according to [1], wherein the number of chain α,β-unsaturated carbonyl groups in the compound (A) is 3 or more in total.
[3] The resist underlayer film-forming composition according to [1] or [2], wherein the compound (A) is a reaction product of a reactant containing a compound (A-1) having an epoxy group and a compound (A-2) having a chain α,β-unsaturated carbonyl group and capable of reacting with an epoxy group.
[4] The resist underlayer film-forming composition according to [3], wherein the reactant further contains a compound (A-3) having two or more groups capable of reacting with an epoxy group.
[5] The resist underlayer film-forming composition according to [4], wherein the compound (A-3) is a compound having two groups capable of reacting with an epoxy group.
[6] The resist underlayer film-forming composition according to any one of [1] to [5], wherein the compound (A) is represented by formula (1) below: 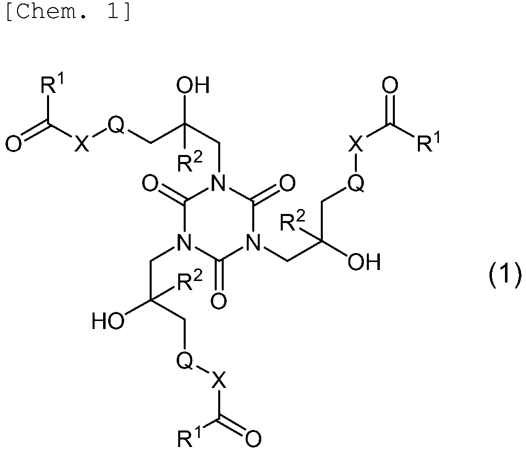
   wherein R¹'s each independently represent a chain carbon-carbon double bond or a chain carbon-carbon triple bond which may be substituted with a hydrocarbon group having 1 to 6 carbon atoms,
   R²'s each independently represent a hydrogen atom or an alkyl group having 1 to 3 carbon atoms,
   X's each independently represent -O- or -N(R)- (R represents a hydrogen atom or an alkyl group having 1 to 6 carbon atoms), and
   Q's each independently represent a single bond or a divalent organic group.
[7] The resist underlayer film-forming composition according to any one of [1] to [6], wherein the solvent (B) contains at least one type selected from a group consisting of an alkylene glycol monoalkyl ether and a monocarboxylic acid ester of an alkylene glycol monoalkyl ether.
[8] The resist underlayer film-forming composition according to any one of [1] to [7], further containing a crosslinking agent (C).
[9] The resist underlayer film-forming composition according to [8], wherein the crosslinking agent (C) is at least one type selected from a group consisting of an aminoplast crosslinking agent and a phenoplast crosslinking agent.
[10] The resist underlayer film-forming composition according to any one of [1] to [9], further containing a curing catalyst (D).
[11] A resist underlayer film which is a cured product of the resist underlayer film-forming composition according to any one of [1] to [10].
[12] A laminate, including:
   a semiconductor substrate; and
   the resist underlayer film according to [11].
[13] A method for producing a semiconductor element, the method including steps of:
   forming a resist underlayer film on a semiconductor substrate using the resist underlayer film-forming composition according to any one of [1] to [10]; and
   forming a resist film on the resist underlayer film.
[14] A pattern forming method, including steps of:
   forming a resist underlayer film on a semiconductor substrate using the resist underlayer film-forming composition according to any one of [1] to [10];
   forming a resist film on the resist underlayer film;
   irradiating the resist film with light or an electron beam, and then developing the resist film to obtain a resist pattern; and
   etching the resist underlayer film using the resist pattern as a mask.

### Advantageous Effects of Invention

According to the present invention, it is possible to provide a resist underlayer film-forming composition capable of forming a resist pattern with small roughness, and a resist underlayer film, a laminate, a method for producing a semiconductor element, and a pattern forming method using the resist underlayer film-forming composition.

### Description of Embodiments

### (Resist underlayer film-forming composition)

The resist underlayer film-forming composition of the present invention contains a compound (A) and a solvent (B).

The resist underlayer film-forming composition may contain a crosslinking agent (C), a curing catalyst (D), and the like.

The compound (A) includes a side chain or a terminal having a chain α,β-unsaturated carbonyl group.

When the compound (A) includes a side chain or a terminal having a chain α,β-unsaturated carbonyl group, a resist pattern with small roughness can be formed on a resist underlayer film formed from the resist underlayer film-forming composition containing the compound (A).

### <Compound (A)>

The compound (A) includes a side chain or a terminal having a chain α,β-unsaturated carbonyl group.

The compound (A) may contain one side chain or terminal having a chain α,β-unsaturated carbonyl group, two or more side chains or terminals, or three or more side chains or terminals.

The compound (A) may be a low molecular weight compound or a high molecular weight compound (polymer).

Examples of the chain α,β-unsaturated carbonyl group located at the side chain or the terminal include a group represented by formula (1A) or (1B) below.

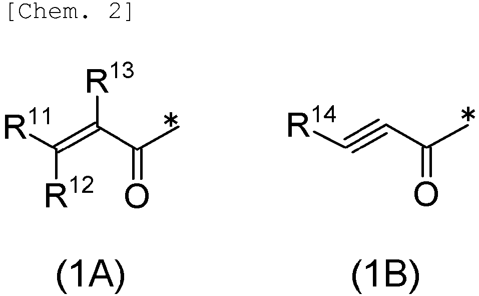

In formulae (1A) and (1B), R¹¹ to R¹⁴ each independently represent a hydrogen atom, a halogen atom, or an organic group having 1 to 6 carbon atoms.
* represents a bond.

Examples of the halogen atom in R¹¹ to R¹⁴ in formula (1A) and formula (1B) include a fluorine atom, a chlorine atom, a bromine atom, and an iodine atom.

Examples of the organic group having 1 to 6 carbon atoms in R¹¹ to R¹⁴ in formula (1A) and formula (1B) include an alkyl group having 1 to 6 carbon atoms, an alkenyl group having 2 to 6 carbon atoms, an alkoxycarbonylalkyl group having 3 to 6 carbon atoms (R^{a}-C(=O)-R^{b}- group: R^{a} represents an alkoxy group having 1 to 4 carbon atoms, and R^{b} represents an alkylene group having 1 to 4 carbon atoms), and an acylamino group having 2 to 6 carbon atoms (R^{a}-C(=O)-N(H)- group: R^{a} represents an alkyl group having 1 to 5 carbon atoms).

R¹¹ and R¹² in formula (1A) are preferably a hydrogen atom.

R¹³ in formula (1A) is preferably a hydrogen atom or a methyl group.

R¹⁴ in formula (1B) is preferably a hydrogen atom.

The compound (A) may have a ring structure.

The ring structure in the present invention may be an aromatic ring or an aliphatic ring (non-aromatic ring).

The ring structure in the present invention may be a hydrocarbon ring or a heterocycle.

Examples of the aromatic ring include an aromatic hydrocarbon ring and an aromatic heterocycle.

The hydrocarbon ring is not particularly limited. The hydrocarbon ring may be a 5-membered ring, a 6-membered ring, or a 7-membered ring.

The heterocycle is not particularly limited. The heterocycle may be a 5-membered ring, a 6-membered ring, or a 7-membered ring.

In the present description, an oxirane ring is not included in the heterocycle.

Examples of the heteroatom included in the heterocycle include a nitrogen atom and an oxygen atom.

Examples of the heterocycle include an isocyanurate structure and a triazine structure.

Examples of the aromatic hydrocarbon ring include a benzene ring and a naphthalene ring.

Examples of the aromatic heterocycle include a triazine structure.

The isocyanurate structure and the triazine structure are represented below.

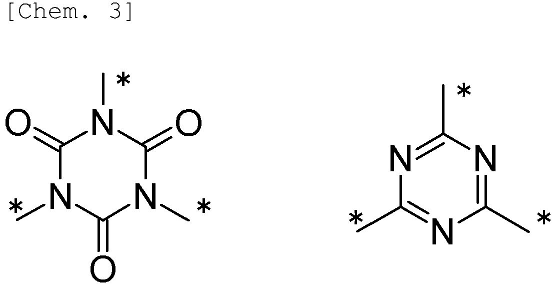

In the formulae, * represents a bond.

From the viewpoint of suitably obtaining the effect of the present invention, the compound (A) is preferably a reaction product of a reactant (also referred to as a reaction raw material or a reaction agent) containing a compound (A-1) and a compound (A-2).

The compound (A-1) is a compound having an epoxy group.

The compound (A-2) is a compound having a chain α,β-unsaturated carbonyl group and capable of reacting with an epoxy group.

Furthermore, the reactant may contain a compound other than the compound (A-1) and the compound (A-2). As such a compound, a compound (A-3) having two or more groups capable of reacting with an epoxy group is preferred.

The reaction may be performed, for example, in the presence of a catalyst. The catalyst is, for example, a quaternary phosphonium salt such as tetrabutylphosphonium bromide or ethyltriphenylphosphonium bromide, or a quaternary ammonium salt such as benzyltriethylammonium chloride. As the amount of the catalyst used, an appropriate amount can be selected and used from a range of 0.1 to 10 mass% with respect to the total mass of a reaction raw material used in the reaction. As the temperature and time for the reaction, for example, optimum conditions can be selected from a range of 80 to 160°C and 2 to 50 hours.

When the reactant does not contain the compound (A-3), the molar ratio of the compounds (A-1) and (A-2) during the reaction: (A-2)/(A-1) is preferably 3 or more and more preferably 3 or more and 3.5 or less.

When the reactant contains the compound (A-3), the molar ratio of the compounds (A-1), (A-2), and (A-3) during the reaction: (A-2)/[(A-1) + (A-3)] is preferably 0.5 or more and 2 or less. By a reaction of a mixture of the compounds (A-1), (A-2), and (A-3) in a molar ratio (A-2)/[(A-1) + (A-3)] in a range of 0.5 or more and 2 or less, an excessive increase in the weight average molecular weight of the reaction product is prevented, and a reaction product in which the compound (A-2) is present at each terminal of the reaction product molecule in a certain degree of proportion can be produced. The presence of the compound (A-2) at the terminal improves the solubility in the solvent.

### <<Compound (A-1)>>

The compound (A-1) has an epoxy group.

The number of epoxy groups contained in the compound (A-1) is not particularly limited, and is, for example, 3 to 6, and from the viewpoint of suitably obtaining the effect of the present invention, the number is preferably 3 or 4.

The epoxy group in the compound (A-1) may or may not be an alicyclic epoxy group.

Examples of the compound (A-1) include compounds having 3 or more epoxy groups in total. Examples of such a compound include a compound represented by formula (A-1-1) below.

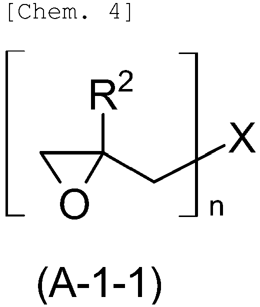

In formula (A-1-1), R²'s each independently represent a hydrogen atom or an alkyl group having 1 to 3 carbon atoms. X represents an n-valent group. n represents an integer of 3 to 6.

X in formula (A-1-1) has, for example, a ring structure.

When X in formula (A-1-1) has a ring structure, X may have one ring structure, or two or more ring structures, but preferably has one ring structure.

R² in formula (A-1-1) is preferably a hydrogen atom or a methyl group, and more preferably a hydrogen atom.

n is an integer of 3 to 6, and preferably 3 or 4.

Examples of the compound represented by formula (A-1-1) include the following compounds.

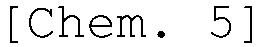

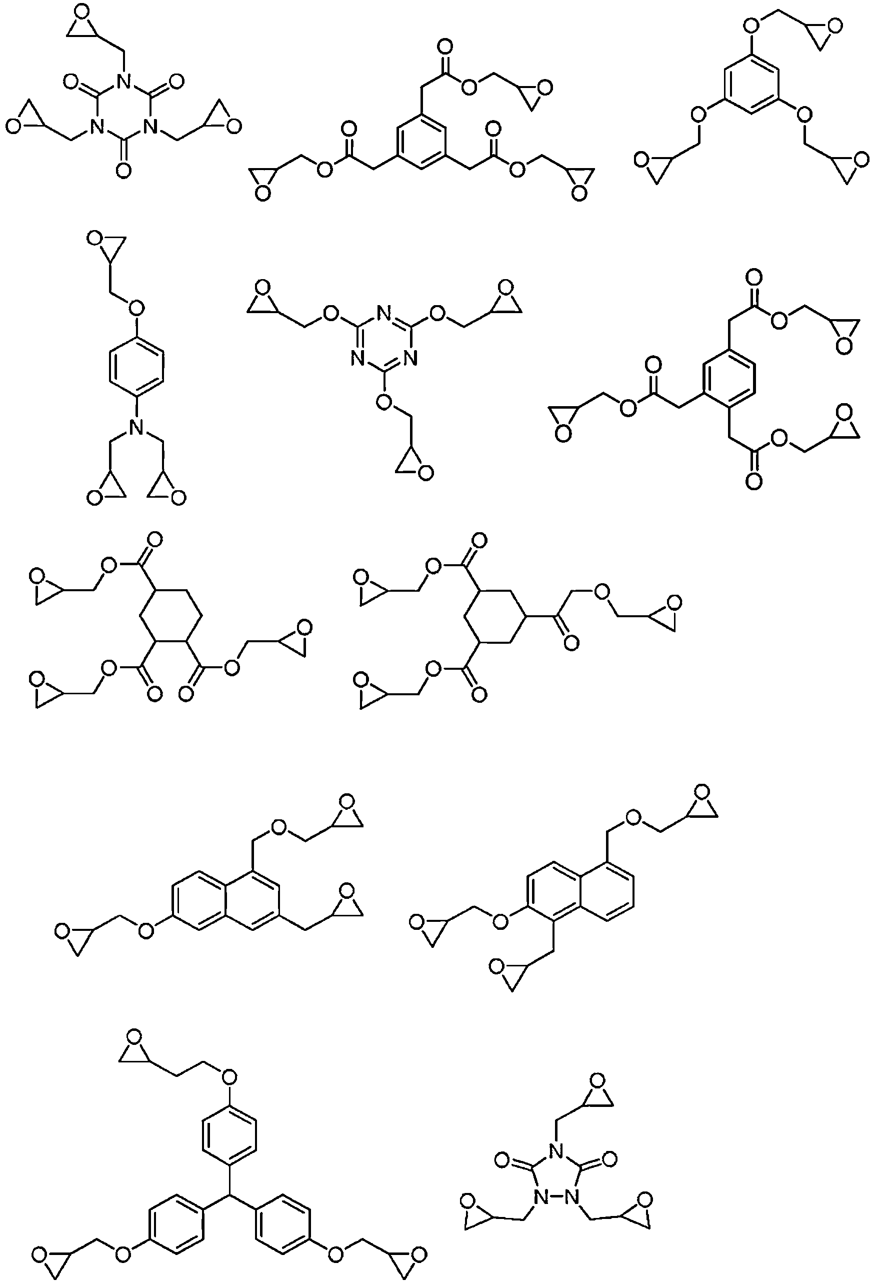

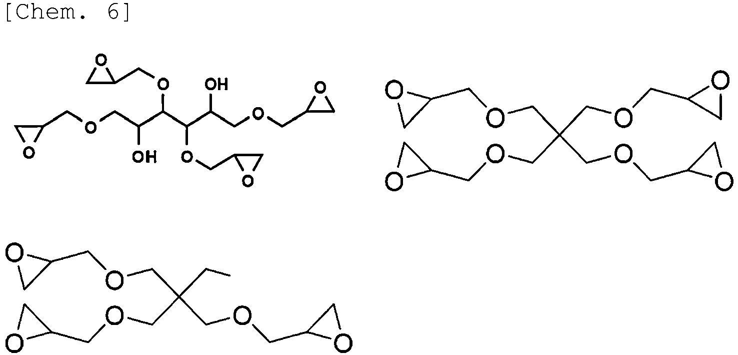

The molecular weight of the compound (A-1) is not particularly limited, and is, for example, 300 to 800.

### <<Compound (A-2)>>

The compound (A-2) is a compound capable of reacting with an epoxy group.

The compound (A-2) has a chain α,β-unsaturated carbonyl group.

The number of "groups capable of reacting with an epoxy group" included in the compound (A-2) may be 1, or 2 or more, but is preferably 1.

Examples of the group capable of reacting with an epoxy group include a carboxy group, an amino group, a phenolic hydroxy group, and an acid dianhydride group.

The number of chain α,β-unsaturated carbonyl groups included in the compound (A-2) may be 1, or 2 or more, but is preferably 1.

As the chain α,β-unsaturated carbonyl group included in the compound (A-2), a group represented by formula (1A) and a group represented by formula (1B) are preferred from the viewpoint of more suitably obtaining the effect of the present invention.

The compound (A-2) may or may not have a ring structure, but preferably does not have a ring structure. Examples of the ring structure include an aliphatic ring and an aromatic ring.

Examples of the compound (A-2) include compounds represented by formulae (A-2-1) to (A-2-6).

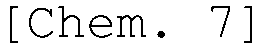

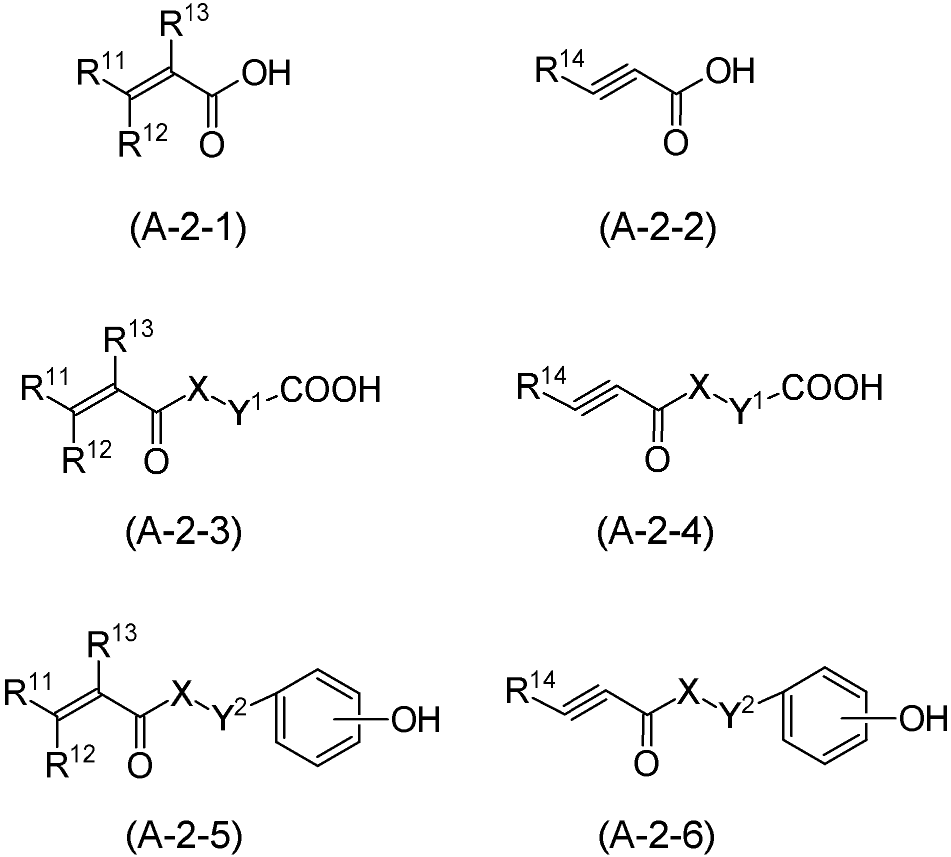

In formula (A-2-1) to formula (A-2-6), R¹¹ to R¹⁴ have the same meanings as R¹¹ to R¹⁴ in formula (1A) and formula (1B), respectively.

X represents -O- or -N(-R)- (R represents a hydrogen atom or an alkyl group having 1 to 6 carbon atoms).

Y¹'s each independently represent an organic group having 1 to 10 carbon atoms.

Y²'s each independently represent a single bond or an organic group having 1 to 6 carbon atoms.

The organic group having 1 to 10 carbon atoms in Y¹ may or may not have a heteroatom.

The organic group having 1 to 10 carbon atoms in Y¹ may or may not have an ester bond.

Examples of the organic group having 1 to 10 carbon atoms in Y¹ include an alkylene group having 1 to 10 carbon atoms. The alkylene group may be linear, branched, or cyclic, or may be a combination of two or more of these.

The organic group having 1 to 6 carbon atoms in Y² may or may not have a heteroatom.

Examples of the organic group having 1 to 6 carbon atoms in Y² include an alkylene group having 1 to 6 carbon atoms. The alkylene group may be linear, branched, or cyclic, or may be a combination of two or more of these.

Specific examples of the compound (A-2) include the following compounds.

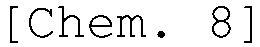

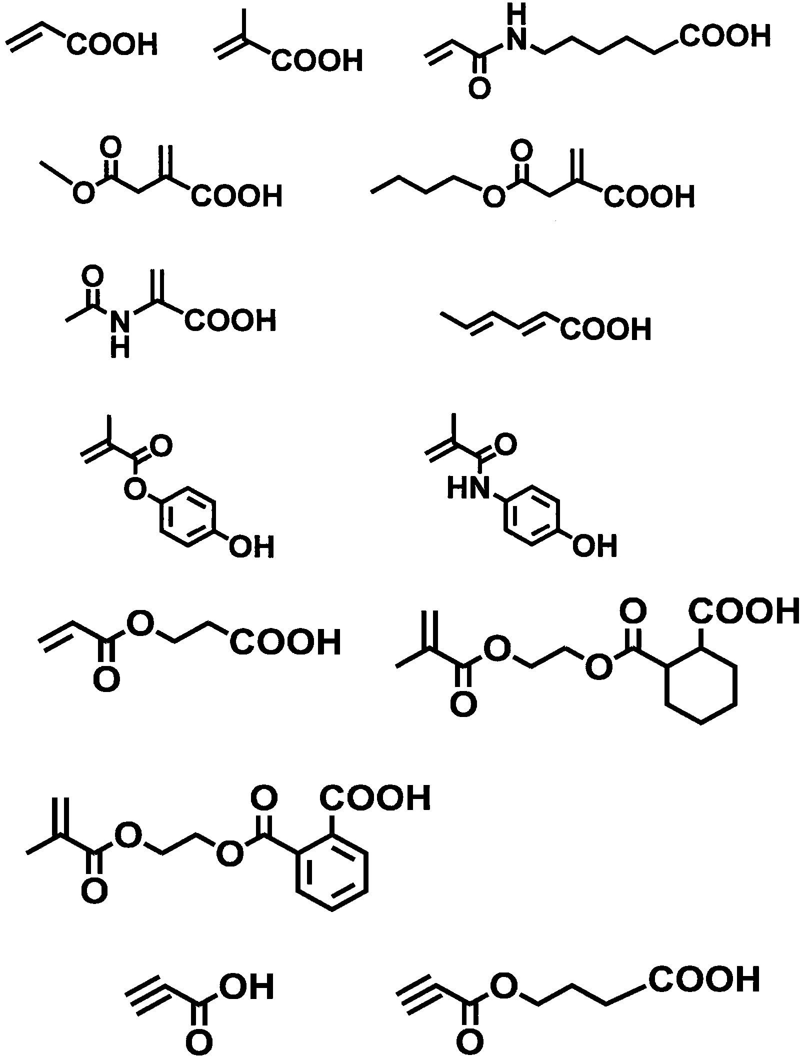

Among them, acrylic acid and methacrylic acid are preferred as the compound (A-2) from the viewpoint of suitably obtaining the effect of the present invention.

### <<Compound (A-3)>>

The compound (A-3) is a compound having two or more groups capable of reacting with an epoxy group.

The compound (A-3) is, for example, a compound having two groups capable of reacting with an epoxy group.

Examples of the group capable of reacting with an epoxy group include a carboxy group, an amino group, a phenolic hydroxy group, and an acid dianhydride group.

When the group capable of reacting with an epoxy group is an acid dianhydride group, a carboxy group remaining after a reaction between the epoxy group and the acid dianhydride group may be present in the compound (A) or may react with at least one type of compound represented by formula (3d) below.

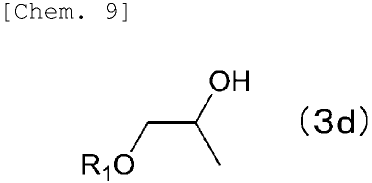

In formula (3d), R₁ represents a methyl group or an ethyl group.

The compound (A-3) contains, for example, an aliphatic ring, an aromatic ring, a heterocycle, a fluorine atom, an iodine atom, or a sulfur atom.

The sulfur atom is preferably contained in the compound (A-3) as a sulfide bond, a disulfide bond, or a sulfonyl group.

Examples of the compound (A-3) include the following compounds.

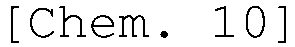

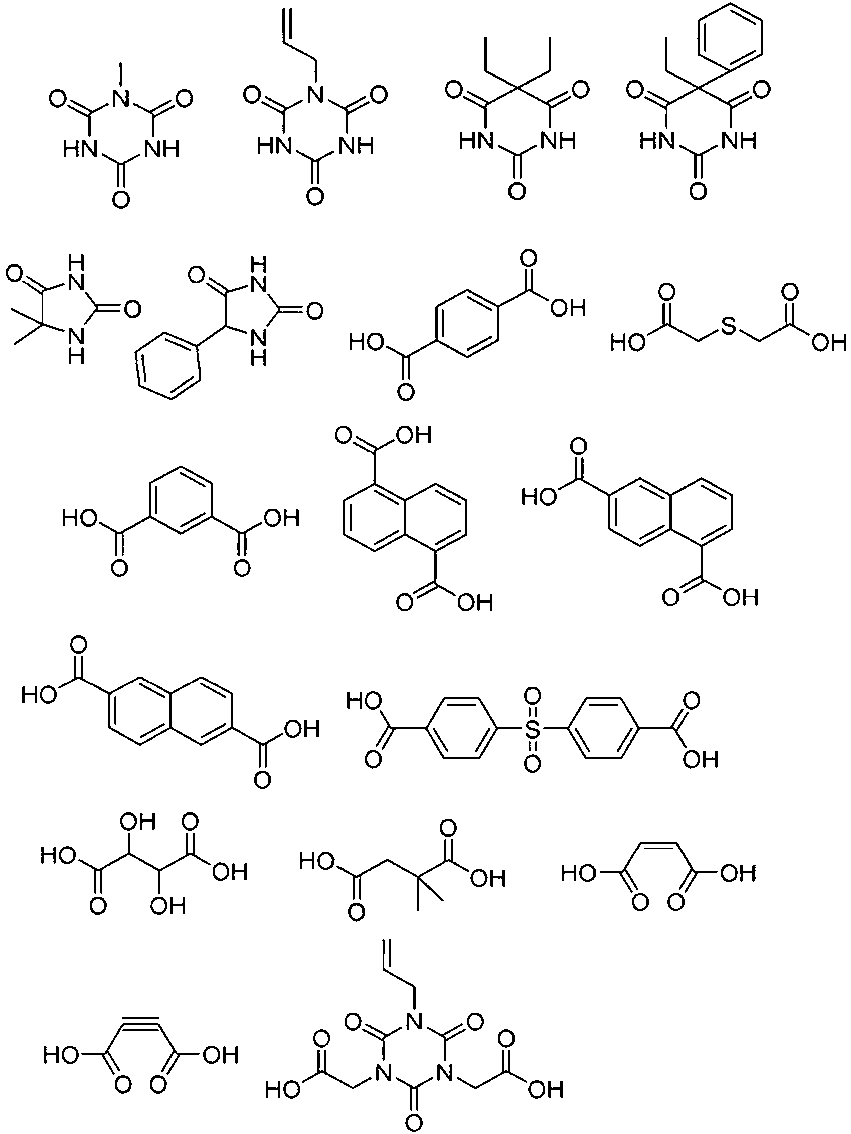

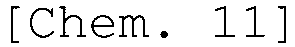

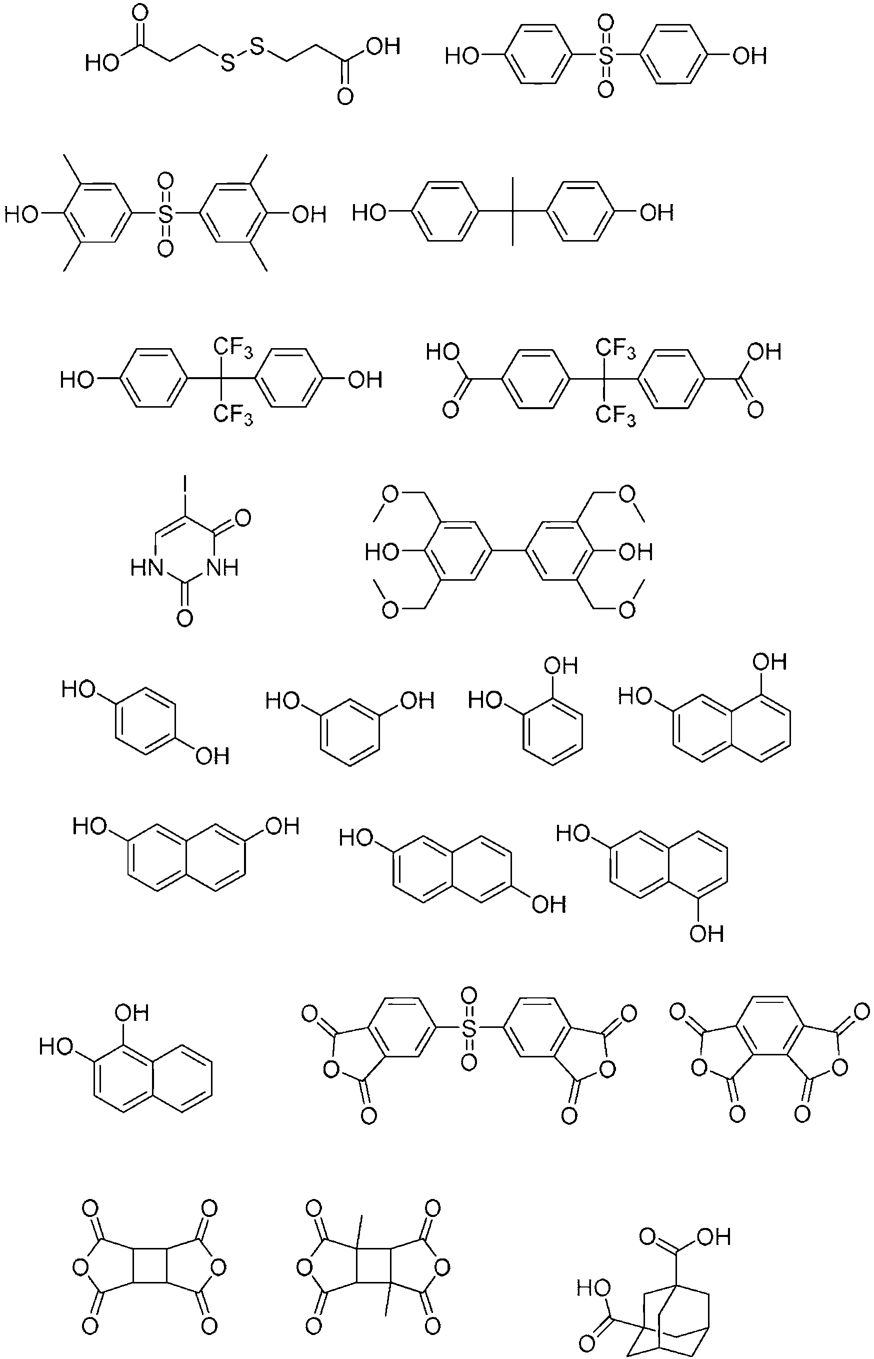

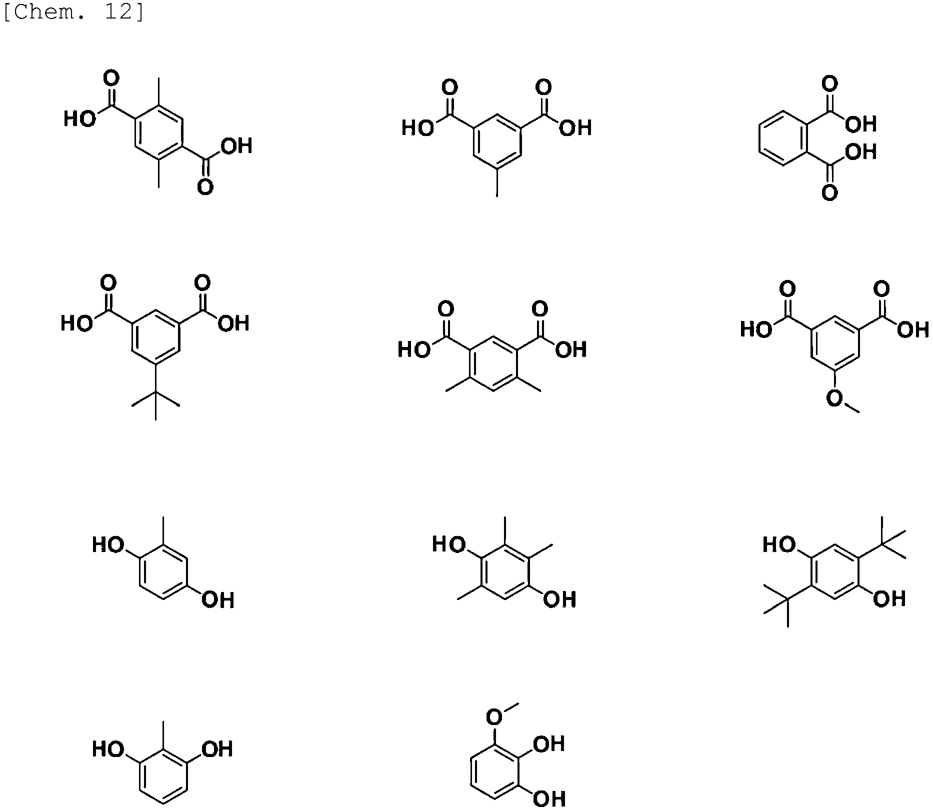

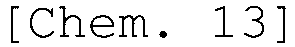

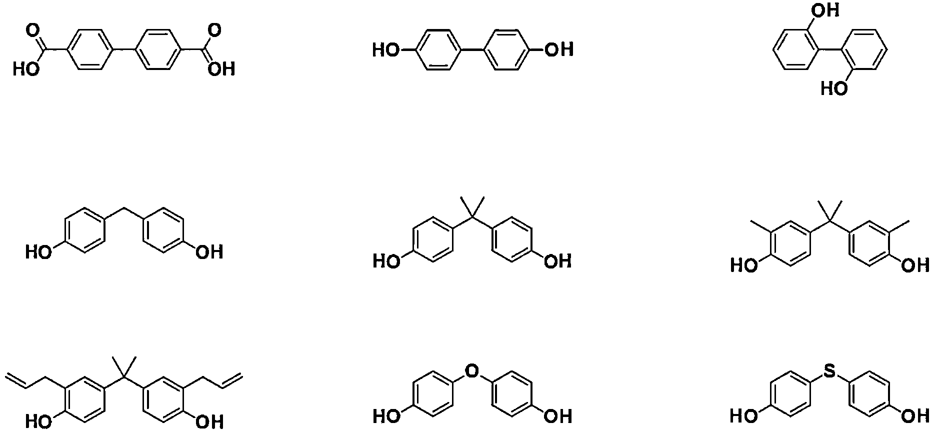

The molecular weight of the compound (A-3) is not particularly limited, and is, for example, 118 to 500.

A molecular weight of 118 is the molecular weight of succinic acid.

The compound (A) is represented by, for example, formula (1) below.

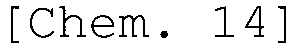

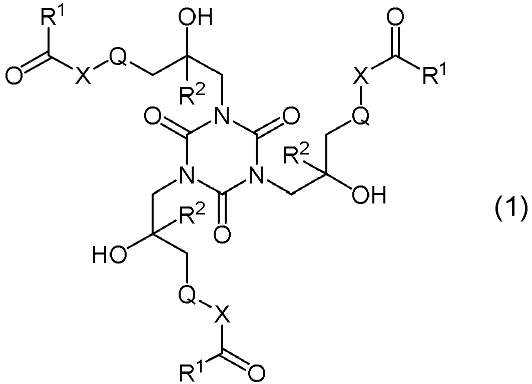

In formula (1), R¹'s each independently represent a chain carbon-carbon double bond or a chain carbon-carbon triple bond which may be substituted with a hydrocarbon group having 1 to 6 carbon atoms.

R²'s each independently represent a hydrogen atom or an alkyl group having 1 to 3 carbon atoms.

X's each independently represent -O- or -N(-R)- (R represents a hydrogen atom or an alkyl group having 1 to 6 carbon atoms).

Q's each independently represent a single bond or a divalent organic group.

Examples of the hydrocarbon group having 1 to 6 carbon atoms as an optional substituent in R¹ in formula (1) include an alkyl group having 1 to 6 carbon atoms, an alkenyl group having 2 to 6 carbon atoms, an alkynyl group having 2 to 6 carbon atoms, and a phenyl group.

Examples of R¹ in formula (1) include the following groups.

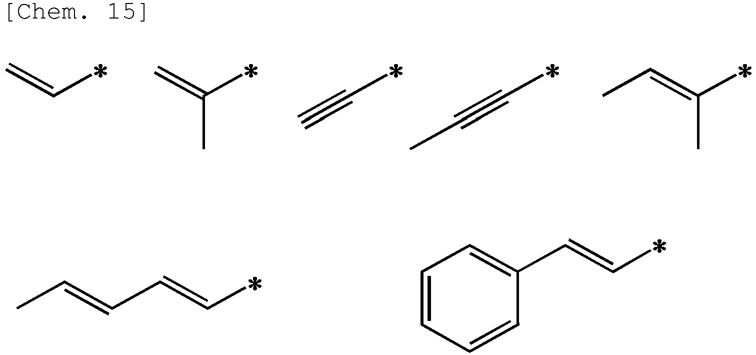

* represents a bond.

As the R¹-C(=O)- group in formula (1), a group represented by formula (1A) and a group represented by formula (1B) are preferred.

R² in formula (1) is preferably a hydrogen atom or a methyl group, and more preferably a hydrogen atom.

The divalent organic group in Q in formula (1) is represented by, for example, formula (2) below.

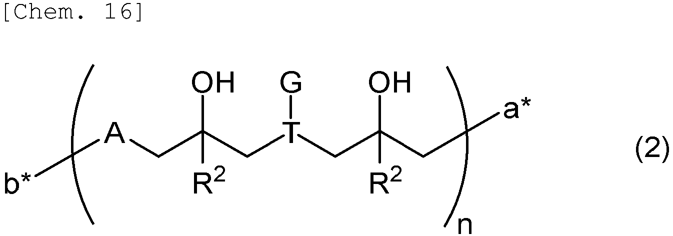

In formula (2), A represents a residue obtained by removing a hydrogen atom bonded to an oxygen atom or a nitrogen atom in the compound (A-3), and when the compound (A-3) is an acid dianhydride, A represents a residue obtained by removing a hydrogen atom bonded to an oxygen atom from at least two carboxy groups of a corresponding tetracarboxylic acid.

R²'s each independently represent a hydrogen atom or an alkyl group having 1 to 3 carbon atoms.

T represents a residue obtained by removing a glycidyl group from the compound represented by formula (A-1-1).

G represents a monovalent organic group.

a* represents a bond on the X side in formula (1).

b* represents a bond on the opposite side to X in formula (1).

n is an integer of 1 or more.

In formula (2), G can further include a partial structure of formula (2), and thus the compound (A) is, for example, a hyperbranched polymer, a dendrimer, a linear polymer, a branched polymer, an oligomer thereof, or a low molecular weight compound thereof.

The lower limit of the weight average molecular weight of the compound (A) is, for example, 500, 1,000, 2,000, or 3,000.

The upper limit of the weight average molecular weight of the compound (A) is, for example, 30,000, 20,000, or 10,000.

The content of the compound (A) in the resist underlayer film-forming composition is not particularly limited, and is preferably 40 mass% to 99 mass%, more preferably 45 mass% to 95 mass%, and particularly preferably 50 mass% to 90 mass% with respect to the film constituent components from the viewpoint of suitably obtaining the effect of the present invention.

In the present invention, the film constituent component means a component other than the solvent contained in the composition.

### <Solvent (B)>

The solvent (B) is not particularly limited, and may be water or an organic solvent.

Examples of the organic solvent include an alkylene glycol monoalkyl ether and a monocarboxylic acid ester of an alkylene glycol monoalkyl ether.

Examples of the alkylene group of the alkylene glycol monoalkyl ether include an alkylene group having 2 to 4 carbon atoms.

Examples of the alkyl group of the alkylene glycol monoalkyl ether include an alkyl group having 1 to 4 carbon atoms.

The number of carbon atoms of the alkylene glycol monoalkyl ether is, for example, 3 to 8.

Examples of the alkylene glycol monoalkyl ether include ethylene glycol monomethyl ether, ethylene glycol monoethyl ether, propylene glycol monomethyl ether, and propylene glycol monoethyl ether.

Examples of the alkylene group of the monocarboxylic acid ester of an alkylene glycol monoalkyl ether include an alkylene group having 2 to 4 carbon atoms.

Examples of the alkyl group of the monocarboxylic acid ester of an alkylene glycol monoalkyl ether include an alkyl group having 1 to 4 carbon atoms.

Examples of the monocarboxylic acid of the monocarboxylic acid ester of an alkylene glycol monoalkyl ether include a saturated monocarboxylic acid having 2 to 4 carbon atoms.

Examples of the saturated monocarboxylic acid having 2 to 4 carbon atoms include acetic acid, propionic acid, and butyric acid.

The number of carbon atoms of the monocarboxylic acid ester of an alkylene glycol monoalkyl ether is, for example, 5 to 10.

Examples of the monocarboxylic acid ester of an alkylene glycol monoalkyl ether include methyl cellosolve acetate, ethyl cellosolve acetate, propylene glycol monomethyl ether acetate, and propylene glycol propyl ether acetate.

Examples of other organic solvents include diethylene glycol monomethyl ether, diethylene glycol monoethyl ether, propylene glycol, toluene, xylene, methyl ethyl ketone, methyl isobutyl ketone, cyclopentanone, cyclohexanone, cycloheptanone, 4-methyl-2-pentanol, methyl 2-hydroxyisobutyrate, ethyl 2-hydroxyisobutyrate, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, 2-heptanone, methoxycyclopentane, anisole, γ-butyrolactone, N-methylpyrrolidone, N,N-dimethylformamide, and N,N-dimethylacetamide.

Among these solvents (B), an alkylene glycol monoalkyl ether and a monocarboxylic acid ester of an alkylene glycol monoalkyl ether are preferred.

One type of these solvents (B) can be used alone or two or more types thereof can be used in combination.

The mass ratio of the organic solvent in the solvent (B) is not particularly limited, but is preferably 50 mass% to 100 mass%.

The content of the solvent (B) in the resist underlayer film-forming composition is not particularly limited, and is preferably 50 mass% to 99.99 mass%, more preferably 75 mass% to 99.95 mass%, and particularly preferably 90 mass% to 99.9 mass%.

### <Crosslinking agent (C)>

The crosslinking agent (C) is not particularly limited.

The crosslinking agent (C) has a structure different from that of the compound (A).

As the crosslinking agent (C), an aminoplast crosslinking agent and a phenoplast crosslinking agent are preferred.

The aminoplast crosslinking agent is an addition condensate of a compound having an amino group, such as melamine or guanamine, and formaldehyde.

The phenoplast crosslinking agent is an addition condensate of a compound having a phenolic hydroxy group and formaldehyde.

Examples of the crosslinking agent (C) include a compound having two or more structures shown below.

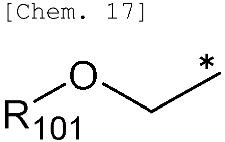

In the structure, R₁₀₁ represents a hydrogen atom, an alkyl group having 1 to 4 carbon atoms, or an alkoxyalkyl group having 2 to 6 carbon atoms. * represents a bond.

The bond is bonded to, for example, a nitrogen atom, a carbon atom included in an aromatic hydrocarbon ring, or the like.

As R₁₀₁, a hydrogen atom, a methyl group, an ethyl group, or a group represented by the following structure is preferred.

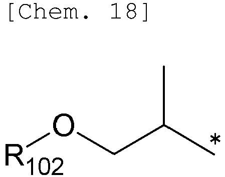

In the structure, R₁₀₂ represents a hydrogen atom, a methyl group, or an ethyl group. * represents a bond.

The crosslinking agent (C) is preferably a melamine compound, a guanamine compound, a glycoluril compound, a urea compound, or a compound having a phenolic hydroxy group. One type of these can be used alone or two or more types thereof can be used in combination.

Examples of the melamine compound include hexamethylolmelamine, hexamethoxymethylmelamine, a compound in which 1 to 6 methylol groups of hexamethylolmelamine are methoxymethylated or a mixture thereof, hexamethoxyethylmelamine, hexaacyloxymethylmelamine, and a compound in which 1 to 6 methylol groups of hexamethylolmelamine are acyloxymethylated or a mixture thereof.

Examples of the guanamine compound include tetramethylolguanamine, tetramethoxymethylguanamine, a compound in which 1 to 4 methylol groups of tetramethylolguanamine are methoxymethylated or a mixture thereof, tetramethoxyethylguanamine, tetraacyloxyguanamine, and a compound in which 1 to 4 methylol groups of tetramethylolguanamine are acyloxymethylated or a mixture thereof.

Examples of the glycoluril compound include tetramethylol glycoluril, tetramethoxy glycoluril, tetramethoxymethyl glycoluril, a compound in which 1 to 4 methylol groups of tetramethylol glycoluril are methoxymethylated or a mixture thereof, and a compound in which 1 to 4 methylol groups of tetramethylol glycoluril are acyloxymethylated or a mixture thereof.

The glycoluril compound may be, for example, a glycoluril derivative represented by formula (1E) below.

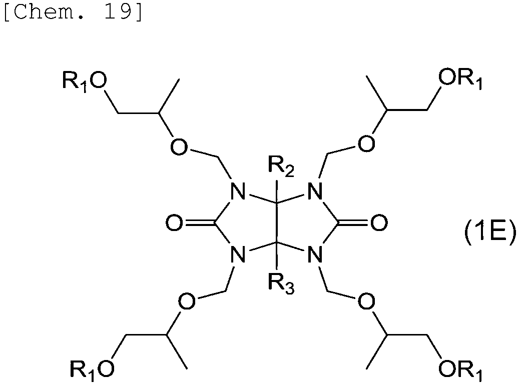

In formula (1E), four R₁'s each independently represent a methyl group or an ethyl group, and R₂ and R₃ each independently represent a hydrogen atom, an alkyl group having 1 to 4 carbon atoms, or a phenyl group.

Examples of the glycoluril derivative represented by formula (1E) include compounds represented by formulae (1E-1) to (1E-6) below.

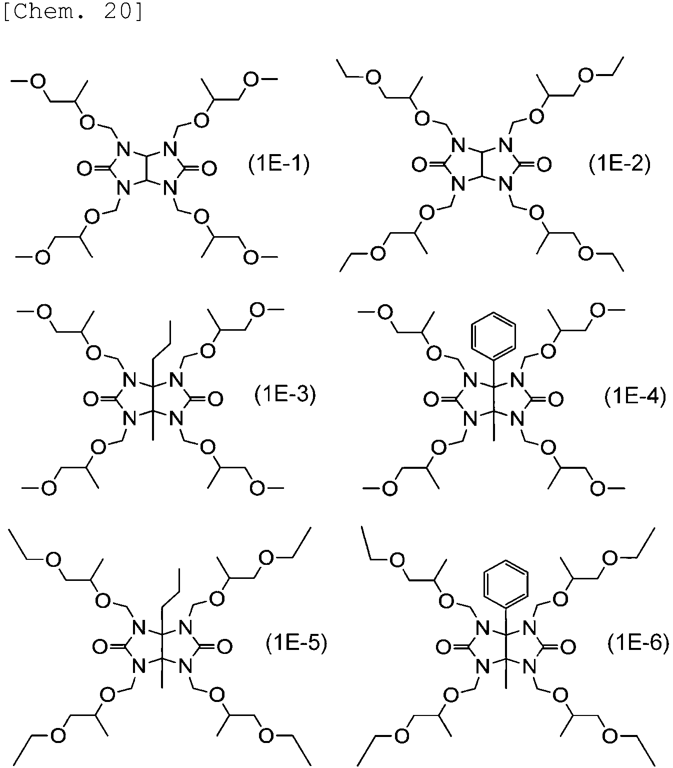

The glycoluril derivative represented by formula (1E) is obtained by, for example, allowing a glycoluril derivative represented by formula (2E) below to react with at least one type of compound represented by formula (3d) below.

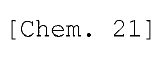

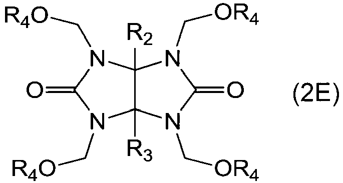

In formula (2E), R₂ and R₃ each independently represent a hydrogen atom, an alkyl group having 1 to 4 carbon atoms, or a phenyl group, and R₄'s each independently represent an alkyl group having 1 to 4 carbon atoms.

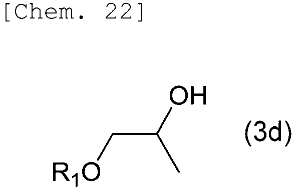

In formula (3d), R₁ represents a methyl group or an ethyl group.

Examples of the glycoluril derivative represented by formula (2E) include compounds represented by formulae (2E-1) to (2E-4) below. Further, examples of the compound represented by formula (3d) include compounds represented by formula (3d-1) and formula (3d-2) below.

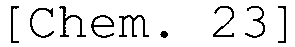

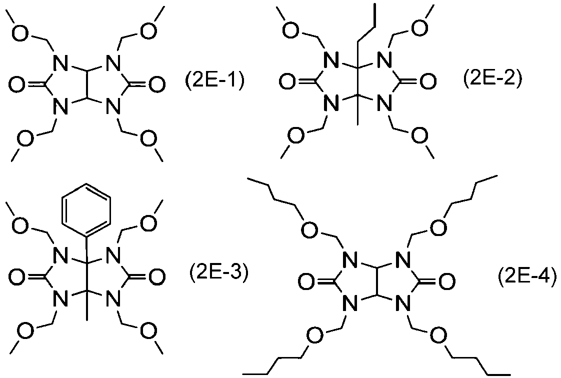

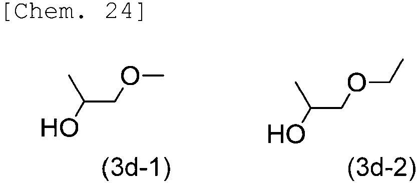

Examples of the urea compound include tetramethylol urea, tetramethoxy methyl urea, a compound in which 1 to 4 methylol groups of tetramethylol urea are methoxymethylated or a mixture thereof, and tetramethoxy ethyl urea.

Examples of the compound having a phenolic hydroxy group include a compound represented by formula (G-1) or formula (G-2) below.

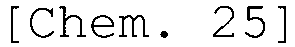

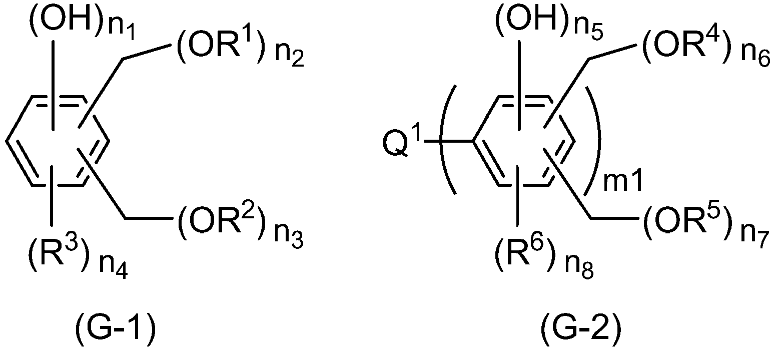

In formula (G-1) and formula (G-2), Q¹ represents a single bond or an m1-valent organic group.

R¹ and R⁴ each represent an alkyl group having 2 to 10 carbon atoms or an alkyl group having 2 to 10 carbon atoms and having an alkoxy group having 1 to 10 carbon atoms.

R² and R⁵ each represent a hydrogen atom or a methyl group.

R³ and R⁶ each represent an alkyl group having 1 to 10 carbon atoms or an aryl group having 6 to 40 carbon atoms.

n₁ represents an integer that meets 1 ≤ n₁ ≤ 3, n₂ represents an integer that meets 2 ≤ n₂ ≤ 5, n₃ represents an integer that meets 0 ≤ n₃ ≤ 3, n₄ represents an integer that meets 0 ≤ n₄ ≤ 3, and an integer that meets 3 ≤ (n₁ + n₂ + n₃ + n₄) ≤ 6.

n₅ represents an integer that meets 1 ≤ n₅ ≤ 3, n₆ represents an integer that meets 1 ≤ n₆ ≤ 4, n₇ represents an integer that meets 0 ≤ n₇ ≤ 3, n₈ represents an integer that meets 0 ≤ n₈ ≤ 3, and an integer that meets 2 ≤ (n₅ + n₆ + n₇ + n₈) ≤ 5.

m1 represents an integer of 2 to 10.

Examples of the compound having a phenolic hydroxy group include a compound represented by formula (G-3) or formula (G-4) below.

The compound represented by formula (G-1) or formula (G-2) may be obtained by a reaction of a compound represented by formula (G-3) or formula (G-4) below with a hydroxyl group-containing ether compound or an alcohol having 2 to 10 carbon atoms.

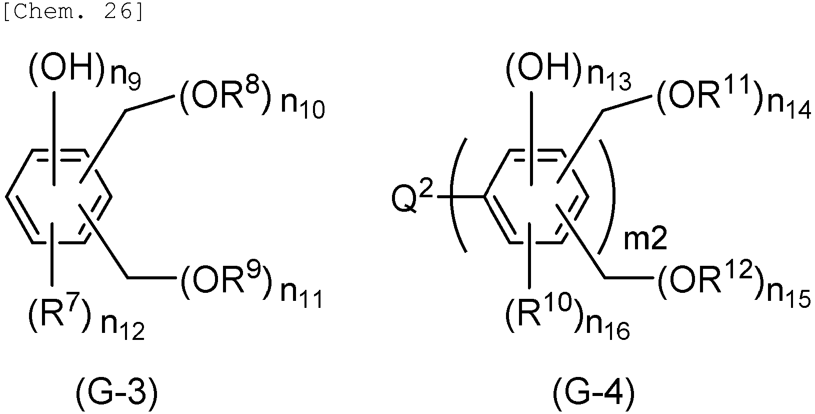

In formula (G-3) and formula (G-4), Q² represents a single bond or an m2-valent organic group.

R⁸, R⁹, R¹¹, and R¹² each represent a hydrogen atom or a methyl group.

R⁷ and R¹⁰ each represent an alkyl group having 1 to 10 carbon atoms or an aryl group having 6 to 40 carbon atoms.

n₉ represents an integer that meets 1 ≤ ng ≤ 3, n₁₀ represents an integer that meets 2 ≤ n₁₀ ≤ 5, n₁₁ represents an integer that meets 0 ≤ n₁₁ ≤ 3, and n₁₂ represents an integer that meets 0 ≤ n₁₂ ≤ 3, and an integer that meets 3 ≤ (n₉ + n₁₀ + n₁₁ + n₁₂) ≤ 6.

n₁₃ represents an integer that meets 1 ≤ n₁₃ ≤ 3, n₁₄ represents an integer that meets 1 ≤ n₁₄ ≤ 4, n₁₅ represents an integer that meets 0 ≤ n₁₅ ≤ 3, and n₁₆ represents an integer that meets 0 ≤ n₁₆ ≤ 3, and an integer that meets 2 ≤ (n₁₃ + n₁₄ + n₁₅ + n₁₆) ≤ 5.

m2 represents an integer of 2 to 10.

Examples of the m2-valent organic group in Q² include an m2-valent organic group having 1 to 4 carbon atoms.

Examples of the compound represented by formula (G-1) or formula (G-2) include the following compounds.

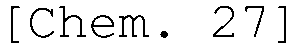

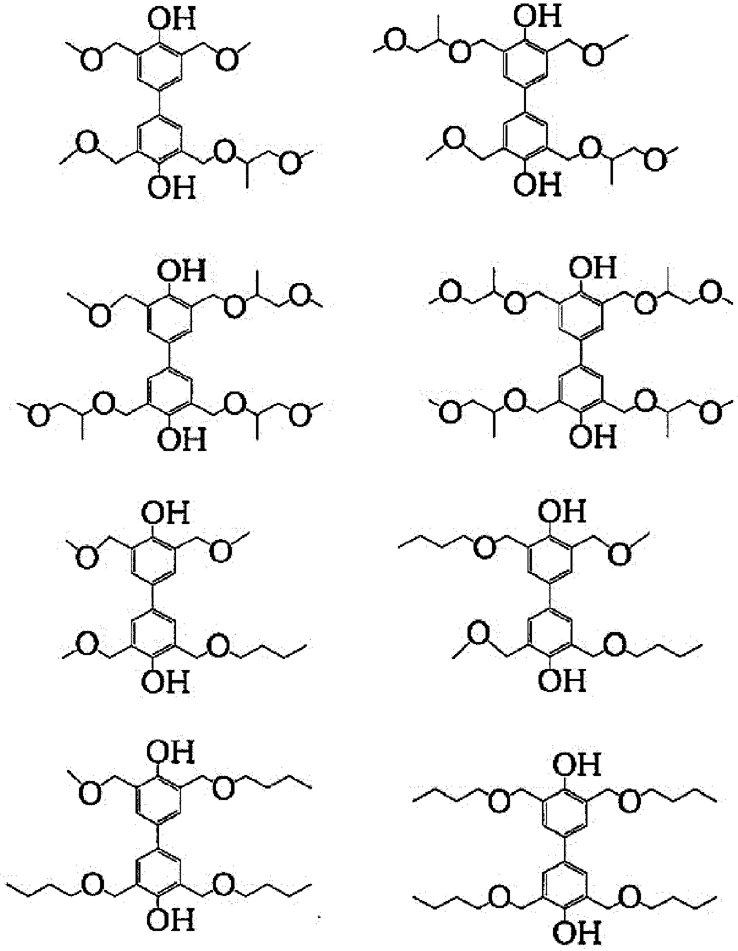

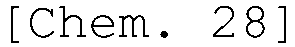

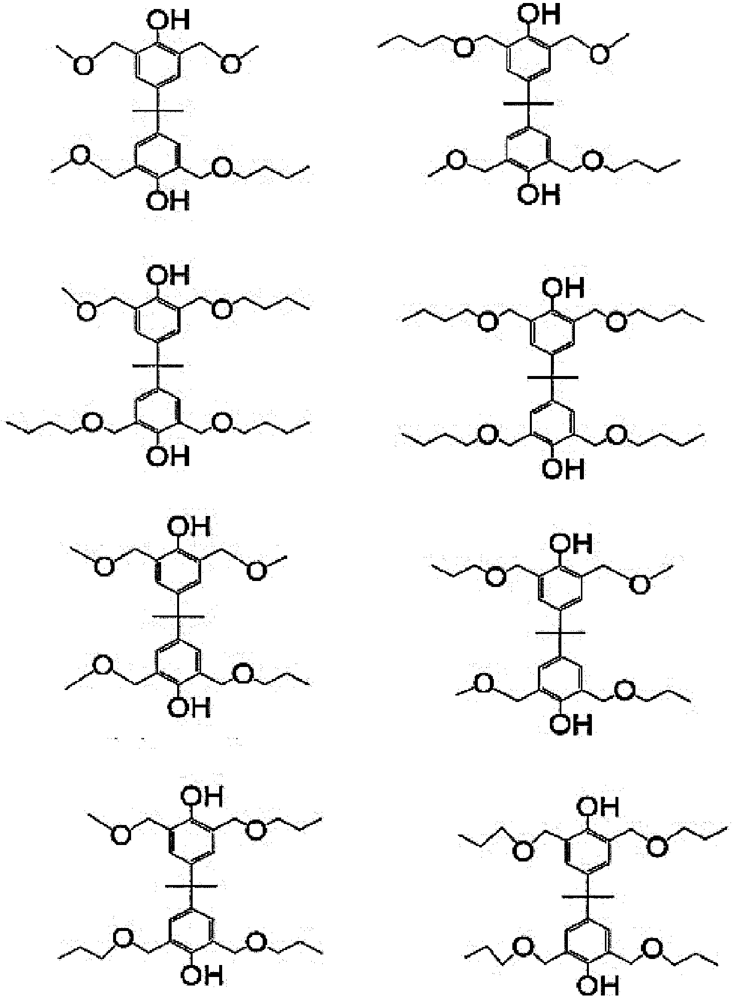

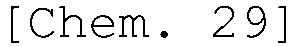

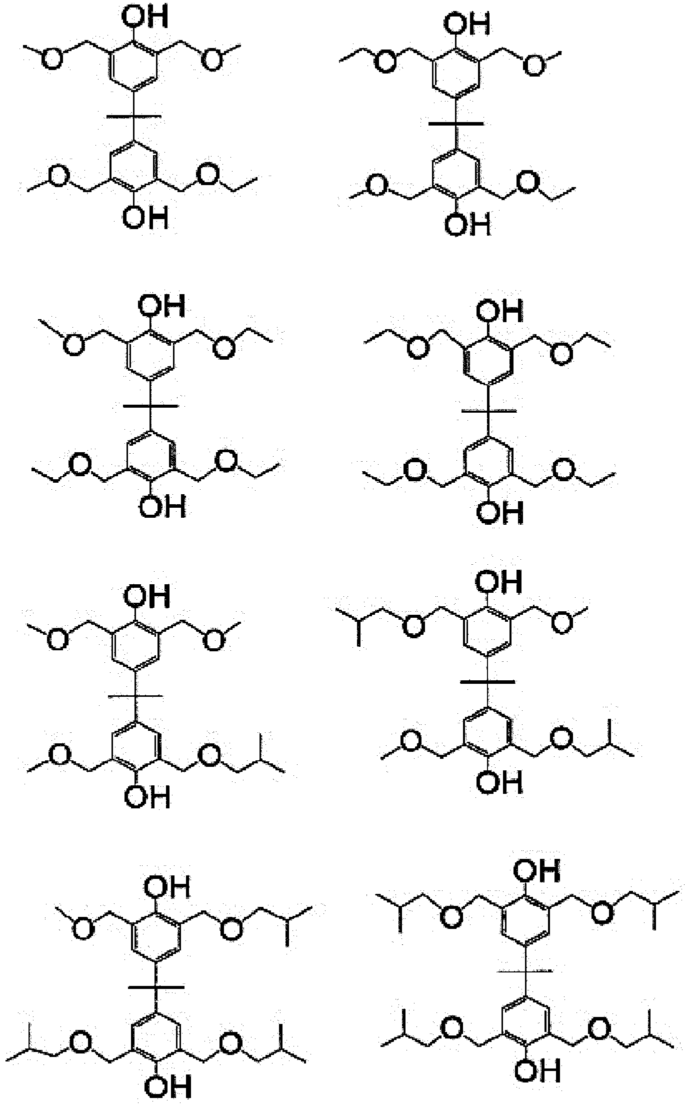

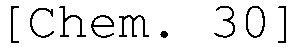

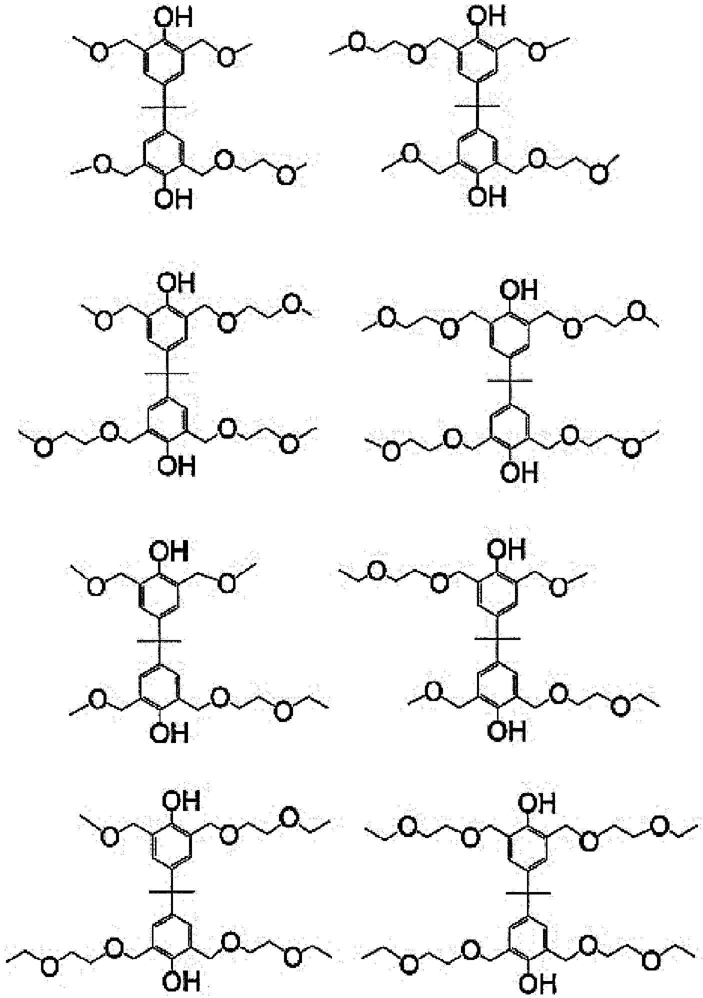

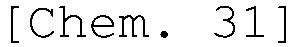

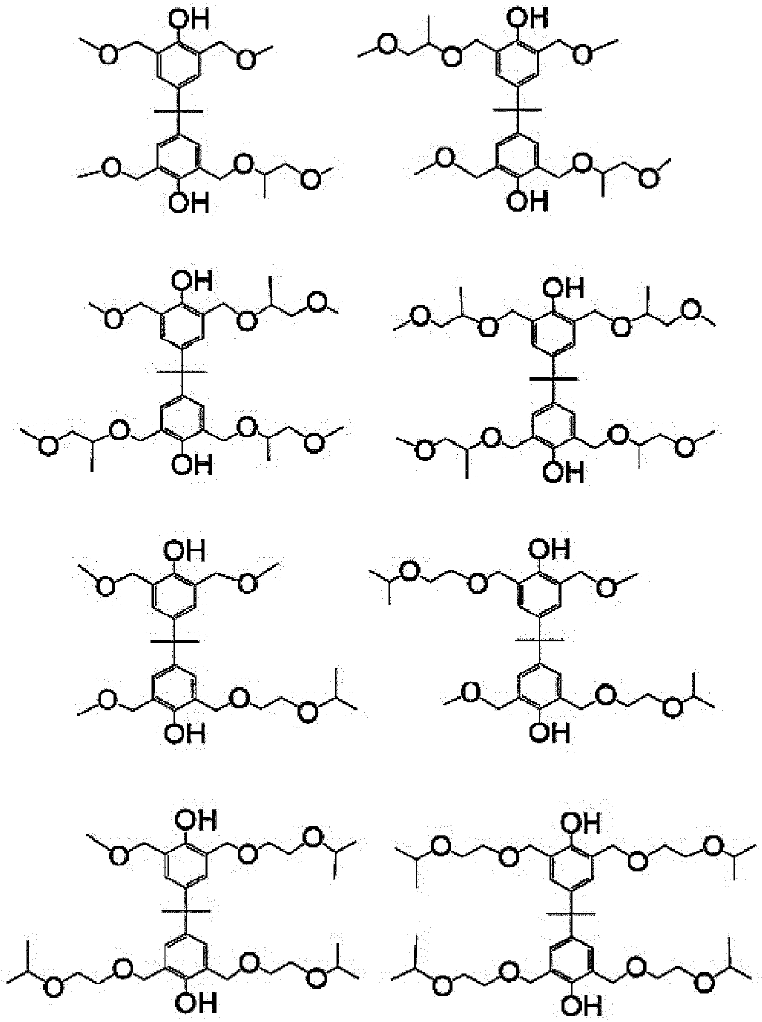

Examples of the compound represented by formula (G-3) or formula (G-4) include the following compounds.

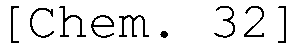

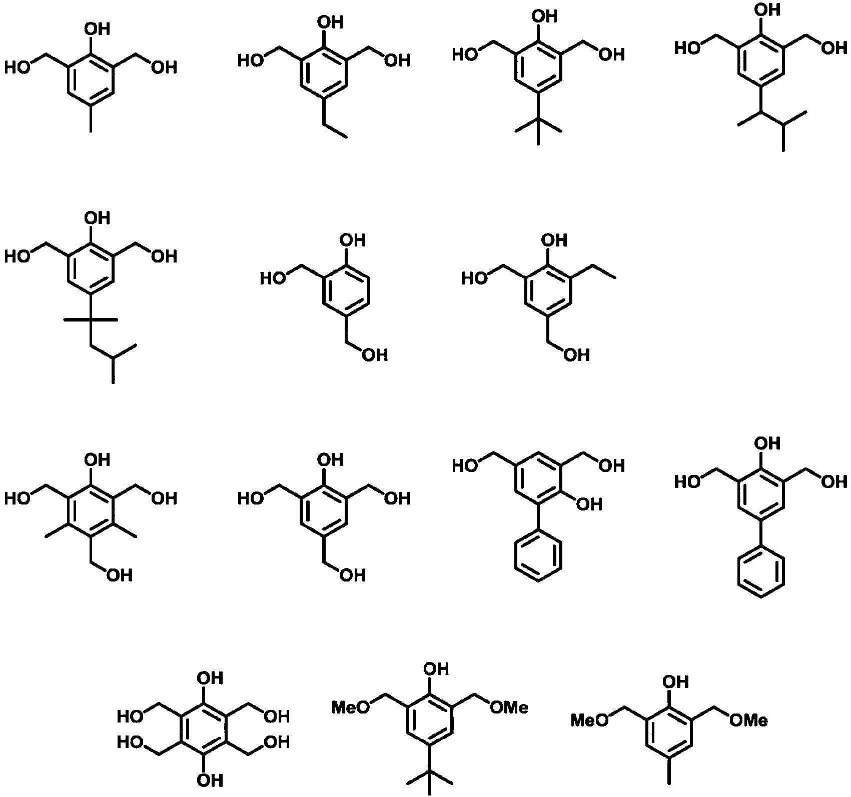

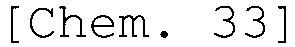

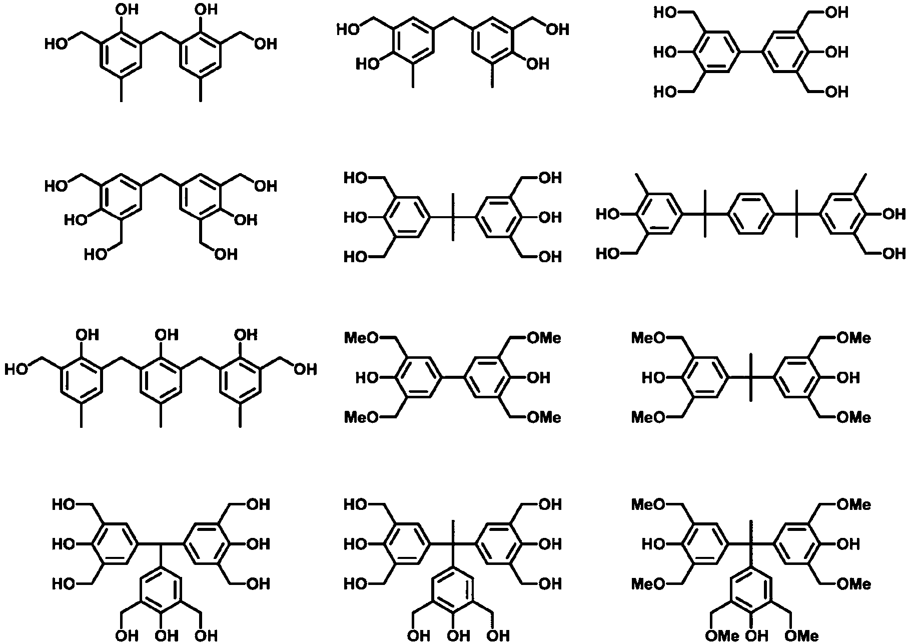

The compounds are available as products of Asahi Organic Chemicals Industry Co., Ltd. and Honshu Chemical Industry Co., Ltd. Examples of the products include TMOM-BP (trade name) manufactured by Asahi Organic Chemicals Industry Co., Ltd.

Among the compounds, the glycoluril compound is preferred. Specifically, tetramethylol glycoluril, tetramethoxy glycoluril, tetramethoxymethyl glycoluril, a compound in which 1 to 4 methylol groups of tetramethylol glycoluril are methoxymethylated or a mixture thereof, and a compound in which 1 to 4 methylol groups of tetramethylol glycoluril are acyloxymethylated or a mixture thereof are preferred, and tetramethoxymethyl glycoluril is more preferred.

The molecular weight of the crosslinking agent (C) is not particularly limited, and is preferably 500 or less.

The content of the crosslinking agent (C) in the resist underlayer film-forming composition is not particularly limited, and is, for example, 1 mass% to 70 mass%, and preferably 5 mass% to 60 mass% with respect to the compound (A).

### <Curing catalyst (D)>

As the curing catalyst (D) contained as an optional component in the resist underlayer film-forming composition, both a thermal acid generator and a photoacid generator can be used, and a thermal acid generator is preferably used.

Examples of the thermal acid generator include sulfonic acid compounds and carboxylic acid compounds such as p-toluenesulfonic acid, trifluoromethanesulfonic acid, pyridinium p-toluenesulfonate (pyridinium p-toluenesulfonic acid), pyridinium phenolsulfonate, pyridinium p-hydroxybenzenesulfonate (p-phenolsulfonic acid pyridinium salt), pyridinium trifluoromethanesulfonate, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, hydroxybenzoic acid, N-methylmorpholine p-toluenesulfonate, N-methylmorpholine p-hydroxybenzenesulfonate, and N-methylmorpholine 5-sulfosalicylate.

Examples of the photoacid generator include onium salt compounds, sulfonimide compounds, and disulfonyldiazomethane compounds.

Examples of the onium salt compounds include iodonium salt compounds such as diphenyliodonium hexafluorophosphate, diphenyliodonium trifluoromethanesulfonate, diphenyliodonium nonafluoronormalbutanesulfonate, diphenyliodonium perfluoronormaloctanesulfonate, diphenyliodonium camphorsulfonate, bis(4-tert-butylphenyl)iodonium camphorsulfonate, and bis(4-tert-butylphenyl)iodonium trifluoromethanesulfonate, and sulfonium salt compounds such as triphenylsulfonium hexafluoroantimonate, triphenylsulfonium nonafluoronormalbutanesulfonate, triphenylsulfonium camphorsulfonate, and triphenylsulfonium trifluoromethanesulfonate.

Examples of the sulfonimide compounds include N-(trifluoromethanesulfonyloxy) succinimide, N-(nonafluoronormalbutanesulfonyloxy) succinimide, N-(camphorsulfonyloxy) succinimide, and N-(trifluoromethanesulfonyloxy) naphthalimide.

Examples of the disulfonyldiazomethane compounds include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyl diazomethane.

As the curing catalyst (D), only one type can be used, or two or more types can be used in combination.

In the case of using the curing catalyst (D), the content ratio of the curing catalyst (D) is, for example, 0.1 mass% to 50 mass%, and preferably 1 mass% to 30 mass% with respect to the crosslinking agent (C).

### <Other components>

To the resist underlayer film-forming composition, a surfactant can be further added in order to further improve the coating property against surface unevenness without generating a pinhole, a striation, and the like.

Examples of the surfactant include nonionic surfactants including linear or branched alkylbenzene sulfonic acids (such as dodecylbenzene sulfonic acid), polyoxyethylene alkyl ethers such as polyoxyethylene lauryl ether, polyoxyethylene stearyl ether, polyoxyethylene cetyl ether, and polyoxyethylene oleyl ether, polyoxyethylene alkyl aryl ethers such as polyoxyethylene octylphenol ether and polyoxyethylene nonylphenol ether, polyoxyethylenepolyoxypropylene block copolymers, sorbitan fatty acid esters such as sorbitan monolaurate, sorbitan monopalmitate, sorbitan monostearate, sorbitan monooleate, sorbitan trioleate, and sorbitan tristearate, and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate, fluorine-based surfactants such as EFTOP EF301, EF303, and EF352 (trade name, manufactured by Tochem Products Co., Ltd.), MEGAFAC F171, F173, and R-30 (trade name, manufactured by DIC Corporation), Fluorad FC430 and FC431 (trade name, manufactured by Sumitomo 3M Limited), Asahi Guard AG710, Surflon S-382, SC101, SC102, SC103, SC104, SC105, and SC106 (trade name, manufactured by AGC Corporation), and an organosiloxane polymer KP341 (manufactured by Shin-Etsu Chemical Co., Ltd.).

The blending amount of such a surfactant is usually 2.0 mass% or less, and preferably 1.0 mass% or less with respect to the total solid content of the resist underlayer film-forming composition.

These surfactants may be added alone, or two or more types thereof can also be added in combination.

The amount of the solid content in the resist underlayer film-forming composition of the present invention, that is, the components excluding the solvent is, for example, 0.01 mass% to 10 mass%.

### (Resist underlayer film)

A resist underlayer of the present invention is a cured product of the above-described resist underlayer film-forming composition.

The resist underlayer film can be produced, for example, by applying the above-described resist underlayer film-forming composition onto a semiconductor substrate and baking the composition.

Examples of the semiconductor substrate to which the resist underlayer film-forming composition is applied include a silicon wafer, a germanium wafer, and a semiconductor wafer formed of a compound such as gallium arsenide, indium phosphide, gallium nitride, indium nitride, or aluminum nitride.

In the case of using a semiconductor substrate having a surface on which an inorganic film is formed, the inorganic film is formed with, for example, an atomic layer deposition (ALD) method, a chemical vapor deposition (CVD) method, a reactive sputtering method, an ion plating method, a vacuum deposition method, or a spin coating method (spin-on-glass: SOG). Examples of the inorganic film include a polysilicon film, a silicon oxide film, a silicon nitride film, a boro-phospho silicate glass (BPSG) film, a titanium nitride film, a titanium nitride oxide film, a tungsten film, a gallium nitride film, and a gallium arsenide film.

The resist underlayer film-forming composition of the present invention is applied onto such a semiconductor substrate with an appropriate application method using a spinner, a coater, or the like. Then, the composition is baked using a heating unit such as a hot plate to form a resist underlayer film. The baking conditions are appropriately selected from a baking temperature of 100°C to 400°C and a baking time of 0.3 minutes to 60 minutes. It is preferred that the baking temperature is 120°C to 350°C and the baking time is 0.5 minutes to 30 minutes, and it is more preferred that the baking temperature is 150°C to 300°C and the baking time is 0.8 minutes to 10 minutes.

The film thickness of the resist underlayer film is, for example, 0.001 µm (1 nm) to 10 µm, 0.002 µm (2 nm) to 1 µm, 0.005 µm (5 nm) to 0.5 µm (500 nm), 0.001 µm (1 nm) to 0.05 µm (50 nm), 0.002 µm (2 nm) to 0.05 µm (50 nm), 0.003 µm (3 nm) to 0.05 µm (50 nm), 0.004 µm (4 nm) to 0.05 µm (50 nm), 0.005 µm (5 nm) to 0.05 µm (50 nm), 0.003 µm (3 nm) to 0.03 µm (30 nm), 0.003 µm (3 nm) to 0.02 µm (20 nm), 0.005 µm (5 nm) to 0.02 µm (20 nm), 0.005 µm (5 nm) to 0.02 µm (20 nm), 0.003 µm (3 nm) to 0.01 µm (10 nm), 0.005 µm (5 nm) to 0.01 µm (10 nm), 0.003 µm (3 nm) to 0.006 µm (6 nm), or 0.005 µm (5 nm).

The method for measuring the film thickness of the resist underlayer film in the present description is as follows.
· Measurement apparatus name: Ellipsometric Film Thickness Measurement System RE-3100 (SCREEN Semiconductor Solutions Co., Ltd.)
·Single wavelength ellipsometer (SWE) mode
·Arithmetic average of measurements at 8 points (for example, measurement is made at 8 points at intervals of 1 cm in X direction of wafer)

### (Laminate)

The laminate of the present invention includes a semiconductor substrate and the resist underlayer film of the present invention.

Examples of the semiconductor substrate include the semiconductor substrates described above.

The resist underlayer film is disposed, for example, on the semiconductor substrate.

### (Method for producing semiconductor element and pattern forming method)

The method for producing a semiconductor element of the present invention includes at least the following steps.
· a step of forming a resist underlayer film on a semiconductor substrate using the resist underlayer film-forming composition of the present invention, and
· a step of forming a resist film on the resist underlayer film.

The pattern forming method of the present invention includes at least the following steps.
· a step of forming a resist underlayer film on a semiconductor substrate using the resist underlayer film-forming composition of the present invention;
· a step of forming a resist film on the resist underlayer film;
· a step of irradiating the resist film with light or an electron beam, and then developing the resist film to obtain a resist pattern; and
· a step of etching the resist underlayer film using the resist pattern as a mask.

The resist layer is usually formed on the resist underlayer film.

The film thickness of the resist layer is, for example, 3,000 nm or less, 2,000 nm or less, 1,800 nm or less, 1,500 nm or less, or 1,000 nm or less. The lower limit is 100 nm, 80 nm, 50 nm, 30 nm, 20 nm, or 10 nm.

The resist film formed on the resist underlayer film with a known method (such as application and baking of a resist composition) is not particularly limited as long as it responds to light or an electron beam (EB) used for irradiation. Both a negative photoresist and a positive photoresist can be used.

In the present description, a resist responding to EB is also referred to as a photoresist.

Examples of the photoresist include a positive photoresist made of a novolac resin and 1,2-naphthoquinonediazide sulfonic acid ester, a chemically amplified photoresist made of a binder having a group, which is decomposed by an acid to increase the alkali dissolution rate, and a photoacid generator, a chemically amplified photoresist made of a low molecular weight compound, which is decomposed by an acid to increase the alkali dissolution rate of the photoresist, an alkalisoluble binder, and a photoacid generator, a chemically amplified photoresist made of a binder having a group, which is decomposed by an acid to increase the alkali dissolution rate, a low molecular weight compound, which is decomposed by an acid to increase the alkali dissolution rate of the photoresist, and a photoacid generator, and a resist containing a metal element. Examples thereof include V146G (trade name) manufactured by JSR Corporation, APEX-E (trade name) manufactured by Shipley, PAR710 (trade name) manufactured by SUMITOMO CHEMICAL COMPANY, LIMITED, and AR2772 and SEPR430 (trade name) manufactured by Shin-Etsu Chemical Co., Ltd. Further, examples thereof include fluorine atom-containing polymer-based photoresists as described in Proc. SPIE, Vol. 3999, 330-334 (2000), Proc. SPIE, Vol. 3999, 357-364 (2000), and Proc. SPIE, Vol. 3999, 365-374 (2000).

Furthermore, so-called resist compositions and metal-containing resist compositions can be used that include resist compositions, radiation-sensitive resin compositions, and high-resolution patterning compositions based on organometallic solutions, described in WO 2019/188595, WO 2019/187881, WO 2019/187803, WO 2019/167737, WO 2019/167725, WO 2019/187445, WO 2019/167419, WO 2019/123842, WO 2019/054282, WO 2019/058945, WO 2019/058890, WO 2019/039290, WO 2019/044259, WO 2019/044231, WO 2019/026549, WO 2018/193954, WO 2019/172054, WO 2019/021975, WO 2018/230334, WO 2018/194123, JP 2018-180525, WO 2018/190088, JP 2018-070596, JP 2018-028090, JP 2016-153409, JP 2016-130240, JP 2016-108325, JP 2016-047920, JP 2016-035570, JP 2016-035567, JP 2016-035565, JP 2019-101417, JP 2019-117373, JP 2019-052294, JP 2019-008280, JP 2019-008279, JP 2019-003176, JP 2019-003175, JP 2018-197853, JP 2019-191298, JP 2019-061217, JP 2018-045152, JP 2018-022039, JP 2016-090441, JP 2015-10878, JP 2012-168279, JP 2012-022261, JP 2012-022258, JP 2011-043749, JP 2010-181857, JP 2010-128369, WO 2018/031896, JP 2019-113855, WO 2017/156388, WO 2017/066319, JP 2018-41099, WO 2016/065120, WO 2015/026482, JP 2016-29498, JP 2011-253185, and the like, but the resist compositions are not limited thereto.

Examples of the resist composition include the following compositions.

An active ray-sensitive or radiation-sensitive resin composition containing a resin A having a repeating unit having an acid-decomposable group in which a polar group is protected by a protecting group to be removed by an action of an acid, and a compound represented by general formula (121) below.

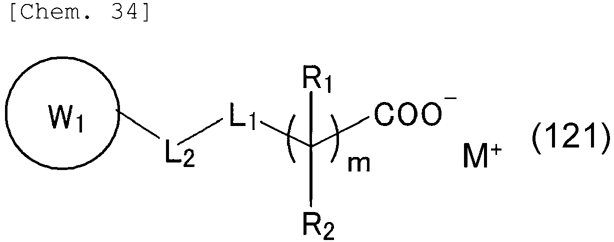

In general formula (121), m represents an integer of 1 to 6.

R₁ and R₂ each independently represent a fluorine atom or a perfluoroalkyl group.

L₁ represents -O-, -S-, -COO-, -SO₂-, or -SO₃-.

L₂ represents an alkylene group which may have a substituent, or a single bond.

W₁ represents a cyclic organic group which may have a substituent.

M⁺ represents a cation.

A metal-containing film-forming composition for extreme ultraviolet or electron beam lithography, containing a compound having a metal-oxygen covalent bond and a solvent, in which metal elements included in the compound belong to periods 3 to 7 of groups 3 to 15 in the periodic table.

A radiation-sensitive resin composition that contains a polymer having a first structural unit represented by formula (31) below and a second structural unit represented by formula (32) below and containing an acid-dissociable group, and that contains an acid generator.

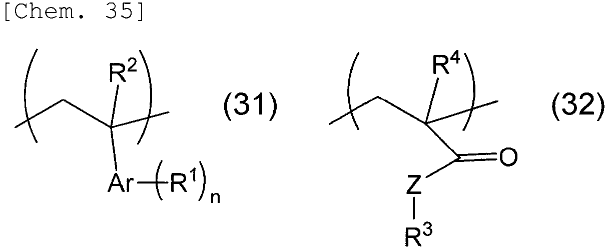

In formula (31), Ar is a group obtained by removing (n + 1) hydrogen atoms from an arene having 6 to 20 carbon atoms, R₁ is a hydroxy group, a sulfanyl group, or a monovalent organic group having 1 to 20 carbon atoms, n is an integer of 0 to 11, when n is 2 or more, a plurality of R¹'s are identical or different, and R₂ is a hydrogen atom, a fluorine atom, a methyl group, or a trifluoromethyl group. In formula (32), R³ is a monovalent group having 1 to 20 carbon atoms and containing the acid-dissociable group, Z is a single bond, an oxygen atom, or a sulfur atom, and R⁴ is a hydrogen atom, a fluorine atom, a methyl group, or a trifluoromethyl group.

A resist composition that contains a resin (A1) including a structural unit having a cyclic carbonate structure, a structural unit represented by the following formula, and a structural unit having an acid labile group, and that contains an acid generator.

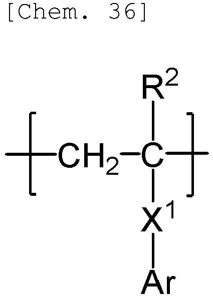

In the formula,
R² represents an alkyl group which has 1 to 6 carbon atoms and may have a halogen atom or represents a hydrogen atom or a halogen atom, X¹ represents a single bond, -CO-O-*, or -CO-NR⁴-*, * represents a bond with -Ar, R⁴ represents a hydrogen atom or an alkyl group having 1 to 4 carbon atoms, and Ar represents an aromatic hydrocarbon group which has 6 to 20 carbon atoms and may have one or more groups selected from the group consisting of a hydroxy group and a carboxyl group.

Examples of the resist film include the following resist film.

A resist film including a base resin including a repeating unit represented by formula (a1) below and/or a repeating unit represented by formula (a2) below, and a repeating unit that generates an acid bonded to a polymer main chain by exposure.

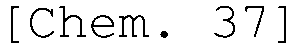

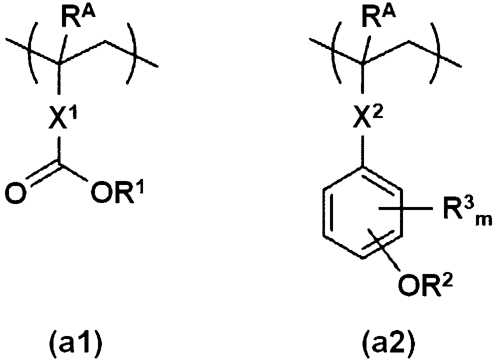

In formula (a1) and formula (a2), R^{A}'s are each independently a hydrogen atom or a methyl group, R¹ and R² are each independently a tertiary alkyl group having 4 to 6 carbon atoms, R³'s are each independently a fluorine atom or a methyl group, m is an integer of 0 to 4, X¹ is a single bond, a phenylene group, a naphthylene group, or a linking group having 1 to 12 carbon atoms and including at least one type selected from an ester bond, a lactone ring, a phenylene group, and a naphthylene group, and X² is a single bond, an ester bond, or an amide bond.

Examples of the resist material include the following resist material.

A resist material containing a polymer having a repeating unit represented by formula (b1) or formula (b2) below.

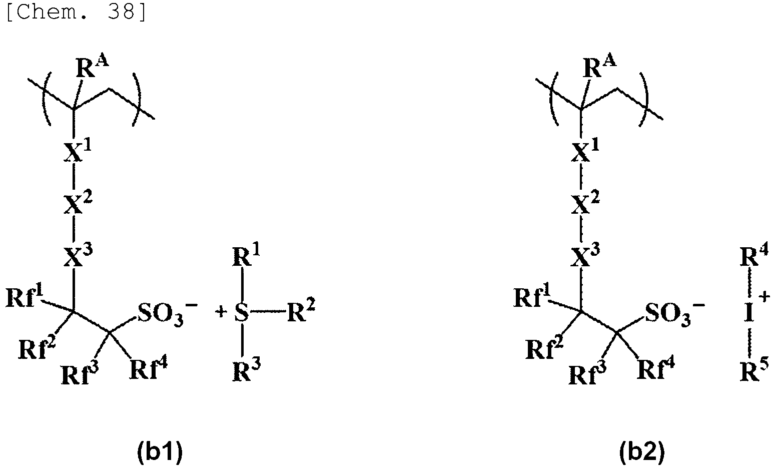

In formula (b1) and formula (b2), R^{A} is a hydrogen atom or a methyl group, X¹ is a single bond or an ester group, X² is a linear, branched, or cyclic alkylene group having 1 to 12 carbon atoms or an arylene group having 6 to 10 carbon atoms, and some of methylene groups included in the alkylene group may be substituted with an ether group, an ester group, or a lactone ring-containing group, and at least one hydrogen atom included in X² is substituted with a bromine atom, X³ is a single bond, an ether group, an ester group, or a linear, branched, or cyclic alkylene group having 1 to 12 carbon atoms, and some of methylene groups included in the alkylene group may be substituted with an ether group or an ester group, Rf¹ to Rf⁴ are each independently a hydrogen atom, a fluorine atom, or a trifluoromethyl group, and at least one of Rf¹ to Rf⁴ is a fluorine atom or a trifluoromethyl group, Rf¹ and Rf² may be combined to form a carbonyl group, R¹ to R⁵ are each independently a linear, branched, or cyclic alkyl group having 1 to 12 carbon atoms, a linear, branched, or cyclic alkenyl group having 2 to 12 carbon atoms, an alkynyl group having 2 to 12 carbon atoms, an aryl group having 6 to 20 carbon atoms, an aralkyl group having 7 to 12 carbon atoms, or an aryloxyalkyl group having 7 to 12 carbon atoms, and some or all of hydrogen atoms of these groups may be substituted with a hydroxy group, a carboxy group, a halogen atom, an oxo group, a cyano group, an amide group, a nitro group, a sultone group, a sulfone group, or a sulfonium salt-containing group, and some of methylene groups included in these groups may be substituted with an ether group, an ester group, a carbonyl group, a carbonate group, or a sulfonic acid ester group, and R¹ and R² may be bonded to form a ring together with a sulfur atom to which R¹ and R² are bonded.

A resist material containing a base resin including a polymer having a repeating unit represented by formula (a) below.

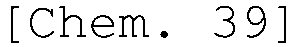

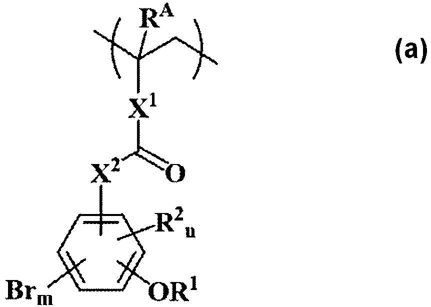

In formula (a), R^{A} is a hydrogen atom or a methyl group, R¹ is a hydrogen atom or an acid labile group, R² is a linear, branched, or cyclic alkyl group having 1 to 6 carbon atoms or a halogen atom other than bromine, X¹ is a single bond, a phenylene group, or a linear, branched, or cyclic alkylene group which has 1 to 12 carbon atoms and may include an ester group or a lactone ring, X² is -O-, - O-CH₂-, or -NH-, m is an integer of 1 to 4, u is an integer of 0 to 3, provided that m + u is an integer of 1 to 4.

A resist composition generating an acid by exposure and having solubility in a developer changed by an action of an acid, the resist composition containing
a base material component (A) that has a solubility in a developer changed by an action of an acid, and a fluorine additive component (F) that exhibits decomposability in an alkaline developer,
in which the fluorine additive component (F) contains a fluororesin component (F1) that has a constituent unit (f1) containing a base-dissociable group and a constituent unit (f2) containing a group represented by general formula (f2-r-1) below.

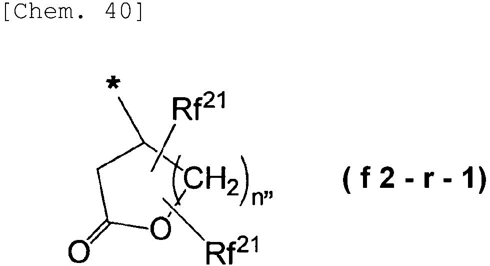

In formula (f2-r-1), Rf²¹'s are each independently a hydrogen atom, an alkyl group, an alkoxy group, a hydroxy group, a hydroxyalkyl group, or a cyano group, n" is an integer of 0 to 2, and * is a bond.

The constituent unit (f1) includes a constituent unit represented by general formula (f1-1) below or a constituent unit represented by general formula (f1-2) below.

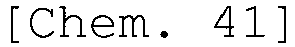

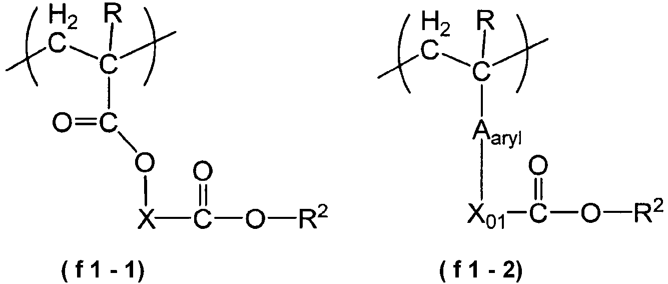

In formulae (f1-1) and (f1-2), R's are each independently a hydrogen atom, an alkyl group having 1 to 5 carbon atoms, or a halogenated alkyl group having 1 to 5 carbon atoms, X is a divalent linking group not having an acid-dissociable site, A_{aryl} is a divalent aromatic cyclic group which may have a substituent, X₀₁ is a single bond or a divalent linking group, and R²'s are each independently an organic group having a fluorine atom.

Examples of a coating, a coating solution, and a coating composition include the following.

A coating including a metal oxo-hydroxo network having an organic ligand via a metal carbon bond and/or a metal carboxylate bond.

An inorganic oxo/hydroxo-based composition.

A coating solution containing: an organic solvent; a first organometallic composition represented by the formula R_{z}SnO_{(2-(z/2)-(x/2))}(OH)ₓ (here, 0 < z ≤ 2 and 0 < (z + x) ≤ 4), the formula R'ₙSnX₄₋ₙ (here, n = 1 or 2), or a mixture thereof, wherein R and R' independently represent a hydrocarbyl group having 1 to 31 carbon atoms and X represents a ligand having a hydrolysable bond to Sn or a combination of such ligands; and a hydrolysable metal compound represented by the formula MX'ᵥ (here, M represents a metal selected from groups 2 to 16 in the periodic table, v is a number of 2 to 6, and X' represents a ligand having a hydrolysable M-X bond or a combination of such ligands).

A coating solution containing an organic solvent and a first organometallic compound represented by the formula RSnO_{(3/2-x/2)}(OH)ₓ (wherein 0 < x < 3) wherein the solution contains about 0.0025 M to about 1.5 M tin, R represents an alkyl group or a cycloalkyl group having 3 to 31 carbon atoms, and the alkyl group or the cycloalkyl group is bonded to tin at a secondary or tertiary carbon atom.

An inorganic pattern forming precursor aqueous solution containing a mixture of water, a metal suboxide cation, a polyatomic inorganic anion, and a radiation-sensitive ligand containing a peroxide group.

Irradiation with light or an electron beam is performed, for example, through a mask (reticle) for formation of a predetermined pattern. For example, an i-line, a KrF excimer laser, an ArF excimer laser, an extreme ultraviolet ray (EUV), or an electron beam (EB) is used. The resist underlayer film-forming composition of the present invention is preferably applied for electron beam (EB) irradiation or extreme ultraviolet ray (EUV: 13.5 nm) irradiation, and more preferably applied for extreme ultraviolet ray (EUV) exposure.

The irradiation energy of the electron beam and the exposure amount of light are not particularly limited.

Post exposure bake (PEB) may be performed after irradiation with light or an electron beam and before development.

The baking temperature is not particularly limited, and is preferably 60°C to 150°C, more preferably 70°C to 120°C, and particularly preferably 75°C to 110°C.

The baking time is not particularly limited, and is preferably 1 second to 10 minutes, more preferably 10 seconds to 5 minutes, and particularly preferably 30 seconds to 3 minutes.

In the development, for example, an alkaline developer is used.

The developing temperature is, for example, 5°C to 50°C.

The developing time is, for example, 10 seconds to 300 seconds.

As the alkaline developer, for example, an aqueous solution of an alkali such as an inorganic alkali such as sodium hydroxide, potassium hydroxide, sodium carbonate, sodium silicate, sodium metasilicate, or ammonia water, a primary amine such as ethylamine or n-propylamine, a secondary amine such as diethylamine or di-n-butylamine, a tertiary amine such as triethylamine or methyldiethylamine, an alcoholamine such as dimethylethanolamine or triethanolamine, a quaternary ammonium salt such as tetramethylammonium hydroxide, tetraethylammonium hydroxide, or choline, or a cyclic amine such as pyrrole or piperidine can be used. Further, an alcohol such as isopropyl alcohol, or a surfactant such as a nonionic surfactant can be added in an appropriate amount to the aqueous solution of an alkali and used. Among these developers, an aqueous solution of a quaternary ammonium salt is preferred, and an aqueous solution of tetramethylammonium hydroxide and an aqueous solution of choline are more preferred. Further, a surfactant or the like can also be added to these developers. It is also possible to use a method in which development is performed with an organic solvent such as butyl acetate in place of the alkaline developer and a portion where the alkali dissolution rate of the photoresist is not improved is developed.

Subsequently, the resist underlayer film is etched using the formed resist pattern as a mask. The etching may be dry etching or wet etching, and dry etching is preferred.

When the inorganic film is formed on the surface of a semiconductor substrate used, the surface of the inorganic film is exposed, and when the inorganic film is not formed on the surface of a semiconductor substrate used, the surface of the semiconductor substrate is exposed. Then, a semiconductor element can be produced through a step of processing the semiconductor substrate with a known method (dry etching method or the like).

### Examples

Next, the contents of the present invention will be specifically described with reference to examples, but the present invention is not limited thereto.

The weight average molecular weight of each of the polymers shown in the following Synthesis Examples 1 to 4 and Comparative Synthesis Example 1 is a measurement result by gel permeation chromatography (hereinafter abbreviated as GPC). For the measurement, a GPC apparatus manufactured by Tosoh Corporation was used, and measurement conditions and the like are as follows.
· GPC column: Shodex GF-710HQ, Shodex GF-510HQ, Shodex GF-310HQ [registered trademark] (Showa Denko K.K.)
·Column temperature: 40°C
·Flow rate: 0.6 ml/min
·Eluent: N,N-dimethylformamide (DMF)
·Standard sample: polystyrene (Tosoh Corporation)

### <Synthesis Example 1>

Into 30.50 g of propylene glycol monomethyl ether in a reaction vessel, 10.00 g of triglycidyl isocyanuric acid (manufactured by Nissan Chemical Corporation), 9.41 g of methacrylic acid (manufactured by Tokyo Chemical Industry Co., Ltd.), 0.36 g of dibutylhydroxytoluene (manufactured by Tokyo Chemical Industry Co., Ltd.), and 0.56 g of tetrabutylphosphonium bromide (manufactured by ACROSS) were added and dissolved. The reaction vessel was purged with nitrogen, and then a reaction was allowed to proceed at 90°C for 24 hours to obtain a product solution. The product solution does not cause cloudiness or the like even when cooled to room temperature, and has good solubility in propylene glycol monomethyl ether. As a result of GPC analysis, the product in the obtained solution had a weight average molecular weight of 600 in terms of standard polystyrene. The reaction product obtained in the present synthesis example has structures represented by formulae (1a) and (1b) below.

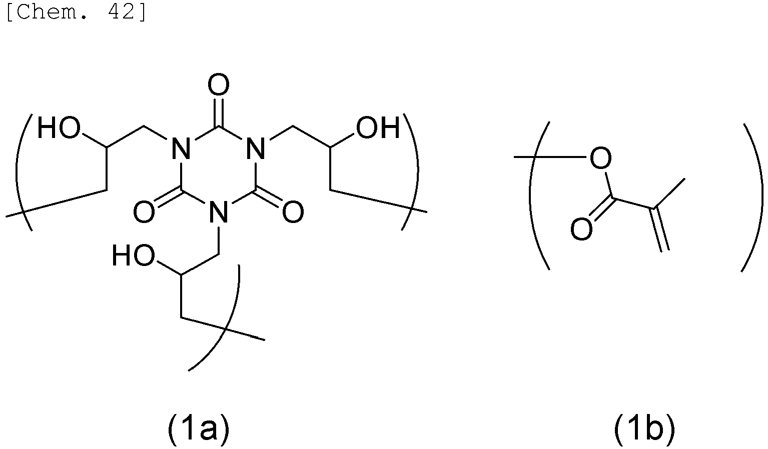

### <Synthesis Example 2>

Into 15.47 g of propylene glycol monomethyl ether in a reaction vessel, 3.00 g of triglycidyl isocyanuric acid (manufactured by Nissan Chemical Corporation), 7.09 g of acrylic acid (manufactured by Tokyo Chemical Industry Co., Ltd.), 0.11 g of dibutylhydroxytoluene (manufactured by Tokyo Chemical Industry Co., Ltd.), and 0.12 g of tetrabutylphosphonium bromide (manufactured by ACROSS) were added and dissolved. The reaction vessel was purged with nitrogen, and then a reaction was allowed to proceed at 90°C for 24 hours to obtain a product solution. The product solution does not cause cloudiness or the like even when cooled to room temperature, and has good solubility in propylene glycol monomethyl ether. As a result of GPC analysis, the product in the obtained solution had a weight average molecular weight of 600 in terms of standard polystyrene. The reaction product obtained in the present synthesis example has structures represented by formulae (1a) and (2b) below.

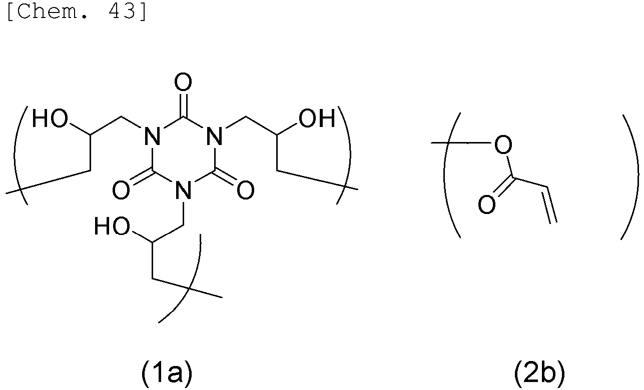

### <Synthesis Example 3>

Into 24.74 g of propylene glycol monomethyl ether in a reaction vessel, 10.00 g of triglycidyl isocyanuric acid (manufactured by Nissan Chemical Corporation), 5.57 g of 3,3'-dithiodipropionic acid (manufactured by Sakai Chemical Industry Co., Ltd., trade name: DTDPA), 3.99 g of methacrylic acid (manufactured by Tokyo Chemical Industry Co., Ltd.), 0.36 g of dibutylhydroxytoluene (manufactured by Tokyo Chemical Industry Co., Ltd.), and 0.56 g of tetrabutylphosphonium bromide (manufactured by ACROSS) were added and dissolved. The reaction vessel was purged with nitrogen, and then a reaction was allowed to proceed at 90°C for 24 hours to prepare a polymer solution. The polymer solution does not cause cloudiness or the like even when cooled to room temperature, and has good solubility in propylene glycol monomethyl ether. As a result of GPC analysis, the polymer in the obtained solution had a weight average molecular weight of 6000 in terms of standard polystyrene. The polymer obtained in the present synthesis example has structures represented by formulae (1a), (2a), and (1b).

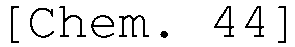

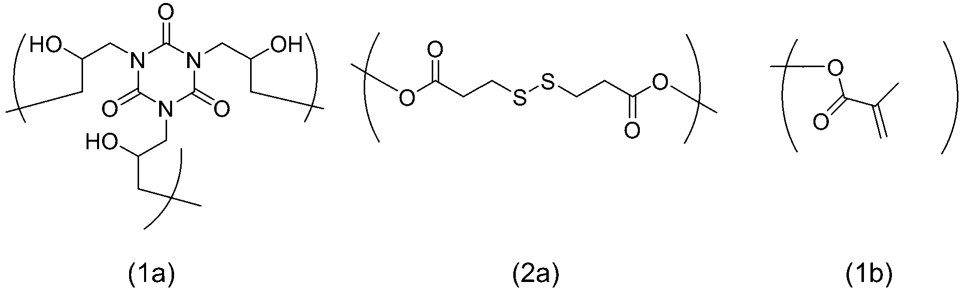

### <Synthesis Example 4>

Into 23.59 g of propylene glycol monomethyl ether in a reaction vessel, 10.00 g of triglycidyl isocyanuric acid (manufactured by Nissan Chemical Corporation), 4.73 g of phthalic acid (manufactured by Tokyo Chemical Industry Co., Ltd.), 4.29 g of methacrylic acid (manufactured by Tokyo Chemical Industry Co., Ltd.), 0.39 g of dibutylhydroxytoluene (manufactured by Tokyo Chemical Industry Co., Ltd.), and 0.60 g of tetrabutylphosphonium bromide (manufactured by ACROSS) were added and dissolved. The reaction vessel was purged with nitrogen, and then a reaction was allowed to proceed at 90°C for 24 hours to prepare a polymer solution. The polymer solution does not cause cloudiness or the like even when cooled to room temperature, and has good solubility in propylene glycol monomethyl ether. As a result of GPC analysis, the polymer in the obtained solution had a weight average molecular weight of 6000 in terms of standard polystyrene. The polymer obtained in the present synthesis example has structures represented by formulae (1a), (3a), and (1b).

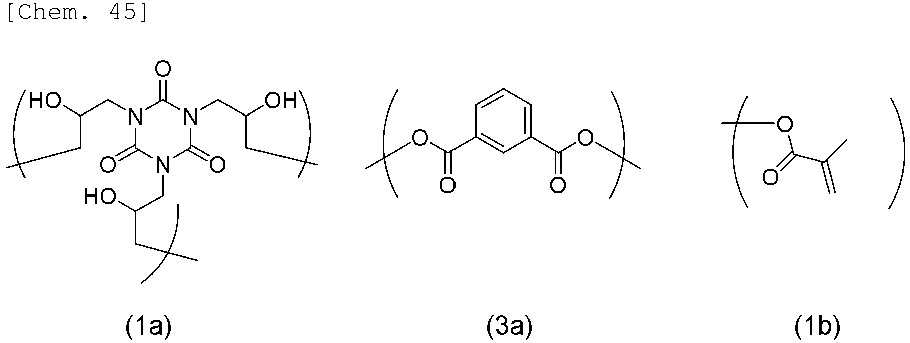

### <Synthesis Example 5>

Into 30.50 g of propylene glycol monomethyl ether in a reaction vessel, 10.00 g of triglycidyl isocyanuric acid (manufactured by Nissan Chemical Corporation), 11.62 g of sorbic acid (manufactured by Tokyo Chemical Industry Co., Ltd.), 0.36 g of dibutylhydroxytoluene (manufactured by Tokyo Chemical Industry Co., Ltd.), and 0.68 g of tetrabutylphosphonium bromide (manufactured by ACROSS) were added and dissolved. The reaction vessel was purged with nitrogen, and then a reaction was allowed to proceed at 90°C for 24 hours to obtain a product solution. The product solution does not cause cloudiness or the like even when cooled to room temperature, and has good solubility in propylene glycol monomethyl ether. As a result of GPC analysis, the product in the obtained solution had a weight average molecular weight of 800 in terms of standard polystyrene. The reaction product obtained in the present synthesis example has structures represented by formulae (1a) and (3b) below.

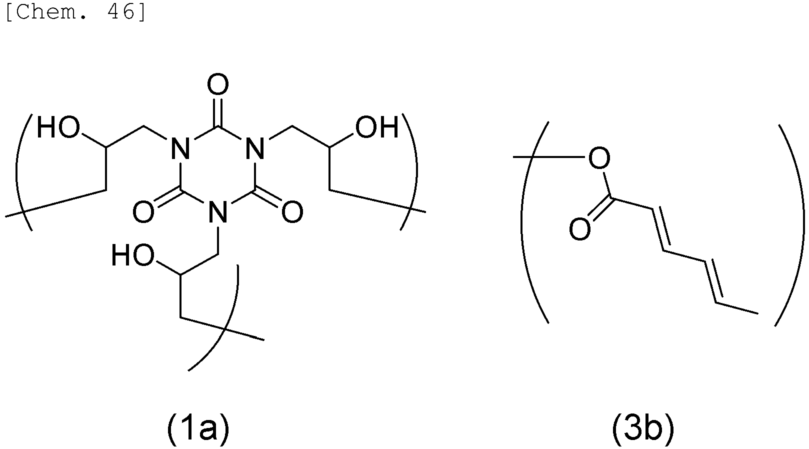

### <Comparative Synthesis Example 1>

Into 12.12 g of propylene glycol monomethyl ether in a reaction vessel, 5.00 g of triglycidyl isocyanuric acid (manufactured by Nissan Chemical Corporation), 4.01 g of butanoic acid (manufactured by Tokyo Chemical Industry Co., Ltd.), and 0.20 g of tetrabutylphosphonium bromide (manufactured by ACROSS) were added and dissolved. The reaction vessel was purged with nitrogen, and then a reaction was allowed to proceed at 90°C for 24 hours to obtain a product solution. The product solution does not cause cloudiness or the like even when cooled to room temperature, and has good solubility in propylene glycol monomethyl ether. As a result of GPC analysis, the product in the obtained solution had a weight average molecular weight of 600 in terms of standard polystyrene. The reaction product obtained in the present synthesis example has structures represented by formulae (1a) and (3b) below.

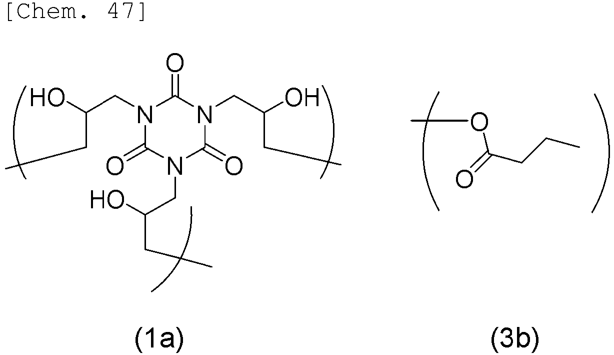

### (Examples and Comparative Examples)

Each of the compounds or polymers obtained in Synthesis Examples 1 to 5 and Comparative Synthesis Example 1, a crosslinking agent, a curing catalyst, and a solvent were mixed in the proportions shown in Table 1, and the mixture was filtered through a 0.1 µm fluororesin filter to prepare solutions of resist underlayer film-forming compositions. Each addition amount was expressed in parts by mass, and the solvent was expressed in composition ratio.

Abbreviations in Table 1 are as follows.
· PL-LI: tetramethoxymethyl glycoluril
· Py-PSA: pyridinium p-hydroxybenzenesulfonic acid
· PGMEA: propylene glycol monomethyl ether acetate
· PGME: propylene glycol monomethyl ether

**[Table 1]**

| | | Polymer | Crosslinking agent | Curing catalyst | Solvent formulation | |
|---|---|---|---|---|---|---|
| Example 1 | Type | Synthesis Example 1 | PL-LI | Py-PSA | PGME | PGMEA |
| | (parts by mass) | 0.131 | 0.065 | 0.003 | 88.95 | 9.98 |
| Example 2 | Type | Synthesis Example 2 | PL-LI | Py-PSA | PGME | PGMEA |
| | (parts by mass) | 0.131 | 0.065 | 0.003 | 88.95 | 9.98 |
| Example 3 | Type | Synthesis Example 3 | PL-LI | Py-PSA | PGME | PGMEA |
| | (parts by mass) | 0.131 | 0.065 | 0.003 | 88.95 | 9.98 |
| Example 4 | Type | Synthesis Example 4 | PL-LI | Py-PSA | PGME | PGMEA |
| | (parts by mass) | 0.131 | 0.065 | 0.003 | 88.95 | 9.98 |
| Example 5 | Type | Synthesis Example 5 | PL-LI | Py-PSA | PGME | PGMEA |
| | (parts by mass) | 0.131 | 0.065 | 0.003 | 88.95 | 9.98 |
| Comparative Example 1 | Type | Comparative Synthesis Example 1 | PL-LI | Py-PSA | PGME | PGMEA |
| | (parts by mass) | 0.131 | 0.065 | 0.003 | 88.95 | 9.98 |

### (Elution test in photoresist solvent)

Each of the resist underlayer film-forming compositions of Examples 1 to 5 and Comparative Example 1 was applied onto a silicon wafer using a spinner. The silicon wafer was baked at 205°C for 60 seconds on a hot plate to obtain a resist underlayer film having a film thickness of 5 nm. These resist underlayer films were immersed in a mixed solution of propylene glycol monomethyl ether acetate/propylene glycol monomethyl ether = 70/30 (mass ratio), which is a solvent used for the photoresist, and a case where the film thickness change was 5 Å or less was evaluated as "good", and a case where the film thickness change was more than 5 Å was evaluated as "poor", and the results are shown in Table 2.

**[Table 2]**

| | Elution test |
|---|---|
| Example 1 | Good |
| Example 2 | Good |
| Example 3 | Good |
| Example 4 | Good |
| Example 5 | Good |
| Comparative Example 1 | Good |

### (Evaluation of resist patterning)

### [Test of resist pattern formation by electron beam lithography system]

Each of the resist underlayer film-forming compositions of Examples 1 to 4 and Comparative Example 1 was applied onto a silicon wafer using a spinner. The silicon wafer was baked at 205°C for 60 seconds on a hot plate to obtain a resist underlayer film having a film thickness of 5 nm. A positive resist solution for EUV was applied onto the resist underlayer film by spin coating, followed by heating to 130°C for 60 seconds to form an EUV resist film. The resist film was exposed under the predetermined conditions using an electron beam lithography system (ELS-G130). After exposure, the film was baked (PEB) at 90°C for 60 seconds, cooled to room temperature on a cooling plate, and developed with an alkaline developer (2.38% TMAH), and then a 30 nm line-and-space pattern/60 nm pitch resist pattern was formed. A scanning electron microscope (CG4100 manufactured by Hitachi High-Technologies Corporation) was used to measure the length of the resist pattern. A scanning electron microscope (CG4100 manufactured by Hitachi High-Technologies Corporation) was used to measure the length of the resist pattern. In the formation of the resist pattern, line width roughness (LWR) with a CD size of 30 nm was compared. The results are shown in Table 3.

**[Table 3]**

| | LWR with CD size of 30 nm |
|---|---|
| Example 1 | 2.44 nm |
| Example 2 | 2.48 nm |
| Example 3 | 2.52 nm |
| Example 4 | 2.51 nm |
| Comparative Example 1 | 2.65 nm |

In all of Examples 1 to 4, favorable LWR was exhibited as compared with Comparative Example 1. From the above results, it is possible to form a resist pattern with good LWR by using the compound (A).

## Claims

1. A resist underlayer film-forming composition, comprising: a compound (A) including a side chain or a terminal having a chain α,β-unsaturated carbonyl group; and a solvent (B).

2. The resist underlayer film-forming composition according to claim 1, wherein the number of chain α,β-unsaturated carbonyl groups in the compound (A) is 3 or more in total.

3. The resist underlayer film-forming composition according to claim 1, wherein the compound (A) is a reaction product of a reactant containing a compound (A-1) having an epoxy group and a compound (A-2) having a chain α,β-unsaturated carbonyl group and capable of reacting with an epoxy group.

4. The resist underlayer film-forming composition according to claim 3, wherein the reactant further contains a compound (A-3) having two or more groups capable of reacting with an epoxy group.

5. The resist underlayer film-forming composition according to claim 4, wherein the compound (A-3) is a compound having two groups capable of reacting with an epoxy group.

6. The resist underlayer film-forming composition according to claim 1, wherein the compound (A) is represented by formula (1) below: 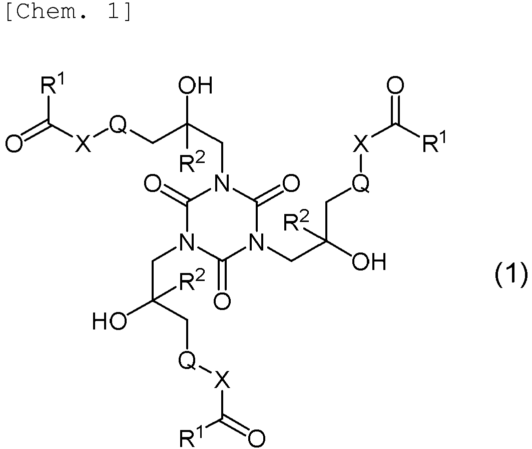
wherein R¹'s each independently represent a chain carbon-carbon double bond or a chain carbon-carbon triple bond which may be substituted with a hydrocarbon group having 1 to 6 carbon atoms,
R²'s each independently represent a hydrogen atom or an alkyl group having 1 to 3 carbon atoms,
X's each independently represent -O- or -N(R)- (R represents a hydrogen atom or an alkyl group having 1 to 6 carbon atoms), and
Q's each independently represent a single bond or a divalent organic group.

7. claim 1, wherein the solvent (B) contains at least one type selected from a group consisting of an alkylene glycol monoalkyl ether and a monocarboxylic acid ester of an alkylene glycol monoalkyl ether.

8. The resist underlayer film-forming composition according to claim 1, further comprising a crosslinking agent (C).

9. The resist underlayer film-forming composition according to claim 8, wherein the crosslinking agent (C) is at least one type selected from a group consisting of an aminoplast crosslinking agent and a phenoplast crosslinking agent.

10. The resist underlayer film-forming composition according to claim 1, further comprising a curing catalyst (D).

11. A resist underlayer film, which is a cured product of the resist underlayer film-forming composition according to any one of claims 1 to 10.

12. A laminate, comprising:
a semiconductor substrate; and
the resist underlayer film according to claim 11.

13. A method for producing a semiconductor element, the method comprising steps of:
forming a resist underlayer film on a semiconductor substrate using the resist underlayer film-forming composition according to any one of claims 1 to 10; and
forming a resist film on the resist underlayer film.

14. A pattern forming method, comprising steps of:
forming a resist underlayer film on a semiconductor substrate using the resist underlayer film-forming composition according to any one of claims 1 to 10;
forming a resist film on the resist underlayer film;
irradiating the resist film with light or an electron beam, and then developing the resist film to obtain a resist pattern; and
etching the resist underlayer film using the resist pattern as a mask.
